(19) Europäisches Patentamt
European Patent Office
Office européen des brevets

(11) **EP 1 489 742 A2**

(12) **EUROPÄISCHE PATENTANMELDUNG**

(43) Veröffentlichungstag:
**22.12.2004 Patentblatt 2004/52**

(51) Int Cl.⁷: **H03H 17/02**, H03H 17/06

(21) Anmeldenummer: **04014120.2**

(22) Anmeldetag: **16.06.2004**

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(30) Priorität: **18.06.2003 DE 10327578**

(71) Anmelder: **Micronas GmbH**
**79108 Freiburg (DE)**

(72) Erfinder: **Hahn, Marko**
**85579 Neubiberg (DE)**

(74) Vertreter: **Bickel, Michael**
**Westphal - Mussgnug & Partner**
**Patentanwälte**
**Mozartstrasse 8**
**80336 München (DE)**

(54) **Verfahren und Vorrichtung zur Filterung eines Signals**

(57) Die vorliegende Erfindung betrifft ein Verfahren und eine Vorrichtung zur Filterung eines Verfahrens bei dem/der folgende Schritte durchgeführt werden:

a) Bereitstellen eines ersten Signalwertes S1, eines zweiten Signalwertes und eines dritten Signalwertes,

b) Ermitteln eines durch den wenigstens einen zweiten Signalwert und den wenigstens einen dritten Signalwert vorgegebenen Intervalls, mit einer von dem wenigstens einen zweiten Signalwert abhängigen ersten Intervallgrenze und einer durch den wenigstens einen dritten Signalwert vorgegeben zweiten Intervallgrenze,

c) Ermitteln eines Mittelwertes aus dem wenigstens einen ausgewählten zweiten Signalwert und dem wenigstens einen ausgewählten dritten Signalwert,

d) Ermitteln, ob der erste Signalwert innerhalb des Intervalls liegt,

e) wenn der erste Signalwert außerhalb des Intervalls liegt: Ermitteln eines ersten mathematischen Abstands zwischen dem ersten Signalwert und der ersten Intervallgrenze und eines zweiten mathematischen Abstands zwischen dem ersten Signalwert und der zweiten Intervallgrenze und eines dritten mathematischen Abstandes zwischen zwischen dem ersten Signalwert und dem Mittelwert zur Bereitstellung eines ersten, eines zweiten und eines dritten Abstandswertes, Auswählen eines Wertes aus einem Wertebereich zwischen dem kleineren der ersten und zweiten Abstandswerte und dem dritten Abstandswert,

f) wenn der erste Signalwert innerhalb des Intervalls liegt: Auswählen eines Wertes aus einem Wertebereich zwischen Null und der Hälfte der Intervallbreite,

g) Setzen des Vorzeichens des ausgewählten Signalwertes abhängig von der Lage des ersten Signalwertes bezogen auf den Mittelwert, um den gefilterten Signalwert bereitzustellen.

EP 1 489 742 A2

**Beschreibung**

Die vorliegende Erfindung betrifft ein Verfahren und eine Vorrichtung zur Filterung, insbesondere zur Hochpassfilterung, eines Signals.

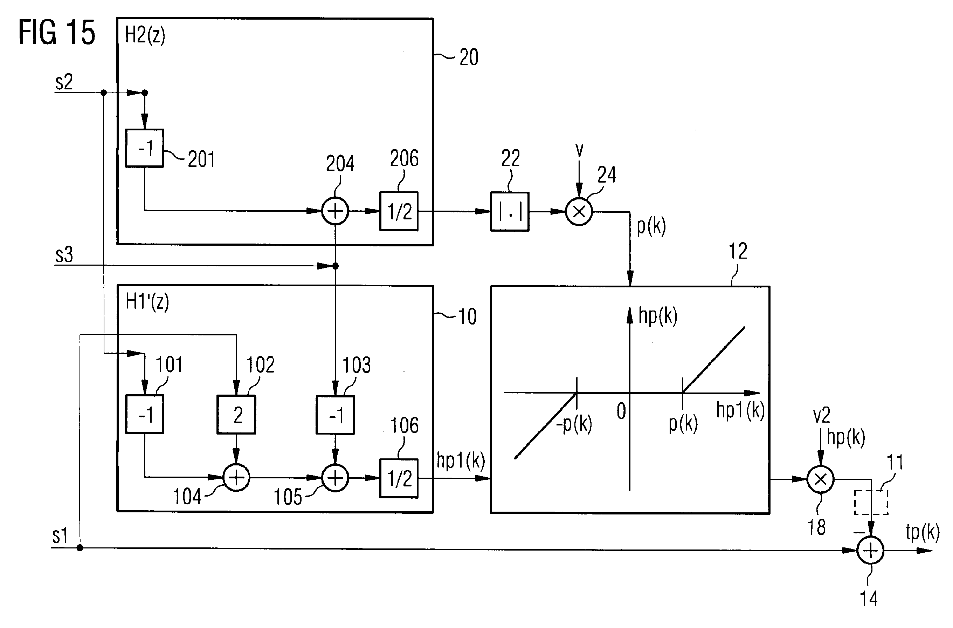

Wie in Figur 15a dargestellt ist, werden Hochpassfilter 200 insbesondere auch für die Tiefpassfilterung von Signalen in(k) verwendet, wobei das Hochpassfilter 200 dazu dient, hochfrequente Signalanteile aus dem Eingangssignal in(k) herauszufiltern, um diese hochfrequenten Signalanteile - gegebenenfalls nach einer Verstärkung oder Dämpfung mittels eines Verstärkers 218- von dem Eingangssignal in(k) zu subtrahieren, um als Ausgangssignal out(k) ein tiefpassgefiltertes Signal zu erhalten. Ein Figur 15a dargestellten Laufzeitglied 215 dient zum Ausgleich der durch das Hochpassfilter 200 eingeführten Signallaufzeiten.

Gängige Hochpassfilter sind lineare Filter, wie beispielsweise das in Figur 200 dargestellte FIR-Filter, dessen Signallaufdiagramm dargestellt ist und dass eine Übertragungsfunktion $h(z) = 0{,}25 \cdot [- z^{-2} + 2z^{-1} - 1]$ besitzt.

Bezogen auf das Eingangssignal in(k) stellt ein derartiges Filter einen Ausgangssignalwert aus jeweils drei aufeinanderfolgenden Eingangssignalwerten zur Verfügung, wobei der Ausgangssignalwert einer normierten Differenz zwischen dem mittleren der drei Signalwerte und dem Mittelwert der beiden anderen Signalwerte entspricht.

Die Wirkungsweise einer derartigen Tiefpassfilteranordnung auf ein beispielhaft in Figur 15b dargestelltes Eingangssignal in(k) ist in Figur 15c dargestellt. Daraus wird deutlich, dass das Tiefpassfilter hochfrequente Signalanteile ausfiltert, dass jedoch auch impulsförmige Signalanteile verkleinert und in ihrer Basis verbreitert werden und dass darüber hinaus Flanken des Eingangssignals partiell abgeflacht werden, was daraus resultiert, dass das Hochpassfilter auch die Impulse und Signalsprünge ausfiltert, die dann von dem Eingangssignal subtrahiert werden.

Der Anwendungsbereich derartiger Filteranordnungen ist sehr groß, wobei die zu filternden diskreten Signale beispielsweise durch Abtastung eines zeitkontinuierlichen Signals gebildet sind. Derartige Signale können jedoch auch Bildinformationswerte repräsentieren, die einem Bild zeilenweise oder spaltenweise entnommen sind. Bei der Verarbeitung von Fernsehsignalen sind Verfahren bekannt, bei denen aus den übertragenen Halbbildern, bei denen nur jede zweite. Zeile Bildinformationen enthält, Vollbilder mit Bildinformationen in jeder Zeile erzeugt werden. Dabei kann es im Fall einer nicht korrekten Interpolation der Zwischenbildzeilen dazu kommen, dass in vertikaler Richtung des Bildes ein Signalverlauf entsteht, bei dem sich von Zeile zu Zeile maximale und minimale Signalwerte (beispielsweise Luminanzwerte oder Chrominanzwerte) abwechseln. Derartige hochfrequente Signalverläufe gilt es zu filtern, um beispielsweise aus einem Wechsel schwarz, weiß von Zeile zur Zeile in allen Zeilen einen Grauwert zu erzeugen. Einzelne Signalsprünge, die im Bild als Helligkeitskanten oder Farbkanten dargestellt sind, sollen durch ein derartiges Filterverfahren jedoch unbeeinflusst bleiben. Gleiches gilt für Signalimpulse, also schmale Hell- oder Dunkelbereiche in dem Bild, die durch das Filterverfahren ebenfalls nicht verwischt werden sollen.

Der vorliegenden Erfindung liegt somit die Aufgabe zugrunde, ein Verfahren und eine Vorrichtung zur Hochpassfilterung eines Signals zur Verfügung zu stellen, das/die in der Lage ist, hochfrequente Signalanteile auszufiltern, Signalimpulse und Signalsprünge jedoch nicht oder nur in geringem Maße ausfiltert.

Dieses Ziel wird durch ein Verfahren gemäß Patentanspruch 1 und durch eine Hochpassfilteranordnung gemäß Anspruch 14 gelöst. Vorteilhafte Ausgestaltungen der Erfindung sind Gegenstand der Unteransprüche.

Das erfindungsgemäße Verfahren zur Hochpassfilterung eines eine Folge von Signalwerten aufweisenden Signals, um ein eine Folge von Signalwerten aufweisendes hochpassgefiltertes Signal zur Verfügung zu stellen, umfasst zur Erzeugung eines Signalwertes des gefilterten Signals jeweils folgende Verfahrensschritte:

    a) Auswählen eines ersten Signalwertes des zu filternden Signals und wenigstens eines dem ersten Signalwert in der Signalfolge vorausgehenden zweiten Signalwertes und wenigstens eines dem ersten Signalwert in der Signalfolge nachfolgenden dritten Signalwertes

    b) Ermitteln eines durch den wenigstens einen zweiten Signalwert und den wenigstens einen dritten Signalwert vorgegebenen Intervalls, mit einer von dem wenigstens einen zweiten Signalwert abhängigen ersten Intervallgrenze und einer durch den wenigstens einen dritten Intervallwert vorgegeben zweiten Intervallgrenze,

    c) Ermitteln eines Mittelwertes aus dem wenigstens einen ausgewählten zweiten Signalwert und dem wenigstens einen ausgewählten dritten Signalwert),

    d) Ermitteln, ob der erste Signalwert innerhalb des Intervalls liegt,

    e) wenn der erste Signalwert außerhalb des Intervalls liegt:

        Ermitteln eines ersten mathematischen Abstands zwischen dem ersten Signalwert und der ersten Intervallgrenze und eines zweiten mathematischen Abstands zwischen dem ersten Signalwert und der zweiten Intervallgrenze und eines dritten mathematischen Abstandes zwischen dem ersten Signalwert und dem Mittelwert zur Bereitstellung eines ersten, zweiten und dritten Abstandswertes, Auswählen eines Wertes aus einem Wertebereich zwischen dem kleineren der ersten und zweiten Abstandswerte und dem dritten Abstandswert,

    f) wenn der erste Signalwert innerhalb des Intervalls liegt:

        Auswählen eines Wertes aus einem Wertbereich zwischen Null und der Hälfte der Intervallbreite,

    g) Setzen des Vorzeichens des ausgewählten Signalwertes abhängig von der Lage des ersten Signalwertes bezogen auf den Mittelwert, um den gefilterten Signalwert bereitzustellen.

Das erfindungsgemäße Verfahren zur Hochpassfilterung ist ein nichtlineares Verfahren, bei dem zunächst ermittelt wird, ob ein in der Signalfolge zwischen dem wenigstens einen zweiten Signalwert und dem wenigstens einen dritten Signalwert liegender erste Signalwert innerhalb oder außerhalb eines durch den zweiten und dritten Signalwert aufgespannten Intervalls liegt. Liegt dieser erste Signalwert innerhalb dieses Intervalls, so wird vorzugsweise ein Filtersignalwert Null erzeugt. Liegt der erste Signalwert außerhalb der durch den wenigstens einen zweiten Signalwert und den wenigstens einen dritten Signalwert gebildeten Intervallgrenzen, so liegt eine impulsförmige Abweichung des ersten Signalwertes gegenüber diesen Intervallgrenzen vor, so dass ein gefilterter Signalwert ungleich Null erzeugt wird, der diese impulsförmige Abweichung dieses ersten Signalwertes gegenüber den Intervallgrenzen wiedergibt. Der Wert des gefilterten Signalwertes wird dabei vorzugsweise derart gewählt, dass er dem Abstand zwischen dem ersten Signalwert und der nächstliegenden Intervallgrenze entspricht.

Das Vorzeichen des gefilterten Signalwertes ist abhängig von der Lage des ersten Signalwertes bezogen auf den Mittelwert der Intervallgrenzen, wobei das Vorzeichen des gefilterten Signalwertes beispielsweise negativ gesetzt wird, wenn der erste Signalwert kleiner als dieser Mittelwert ist und wobei dieses Vorzeichen vorzugsweise positiv gesetzt wird, wenn dieser erste Signalwert größer als dieser Mittelwert ist.

Um Rauscheinflüsse bei der Hochpassfilterung zu unterdrücken ist vorzugsweise vorgesehen, bei der Ermittlung des ersten, zweiten und dritten Abstandes den hieraus resultierenden Abstandswert jeweils zu Null zu setzen, wenn der Abstand kleiner als ein vorgegebener Grenzwert ist. Dem liegt die Erkenntnis zugrunde, dass geringe Abweichungen zwischen Signalen beispielsweise zwischen einem ersten Signalwert und der durch einen der benachbarten Signalwerte gebildeten nächstliegenden Intervallgrenze üblicherweise aus Rauscheinflüssen resultieren, die durch das erläuterte Vorgehen unterdrückt werden können.

Bei einem Ausführungsbeispiel der Erfindung ist vorgesehen, dass die Intervallgrenzen durch einen dem ersten Signalwert in der Signalfolge vorangehenden zweiten Signalwert und einen dem ersten Signalwert in der Signalfolge nachfolgenden dritten Signalwert gebildet werden. Bei einer weiteren Ausführungsform ist vorgesehen, mehrere dem ersten Signalwert vorangehende zweite Signalwerte und mehrere der ersten Signalwert nachfolgende dritte Signalwerte auszuwählen, zwischen jedem zweiten Signalwert und jedem dritten Signalwert ein Intervall zu bilden und beispielsweise denjenigen zweiten Signalwert und denjenigen dritten Signalwert als Intervallgrenzen auszuwählen, die das größte Intervall oder die das kleinste Intervall aufspannen. Grundsätzliche kann auch jeweils ein beliebiger der zweiten und dritten Signalwerte ausgewählt werden.

Vorzugsweise wird der gefilterte Signalwert auf einen oberen oder unteren Grenzwert begrenzt.

Das erfindungsgemäße Verfahren eignet sich insbesondere zur Tiefpassfilterung, wobei hierfür vorgesehen ist, ein hochpassgefiltertes Signal gemäß dem erfindungsgemäßen Verfahren zur Verfügung zu stellen und das tiefpassgefilterte Signal aus dem hochpassgefiltertem Signal und dem Eingangssignal zu erzeugen.

In einfachsten Fall wird dabei das hochpassgefilterte Signal von dem verzögerten Eingangssignal subtrahiert, um ein tiefpassgefiltertes Signal zur Verfügung zu stellen.

Bei einer weiteren Ausführungsform eines das erfindungsgemäße Hochpassfilterverfahren anwendende Tiefpassfilterverfahren sind folgende Verfahrensschritte vorgesehen:

- Begrenzen des hochpassgefilterten Signals zur Erzeugung eines begrenzten hochpassgefilterten Signals,

- Subtrahieren des begrenzten hochpassgefilterten Signals von dem Eingangssignal zur Erzeugung eines ersten tiefpassgefilterten Signals,

- Subtrahieren des begrenzten hochpassgefilterten Signals von dem hochpassgefilterten Signal zur Erzeugung eines Differenzsignals ,

- Begrenzen eines von dem Differenzsignal abhängigen Signals,

- Addieren des ersten tiefpassgefilterten Signals und des begrenzten Differenzsignals zur Bildung des tiefpassgefilterten Signals.

Bei einer Abwandlung des zuletzt erläuterten Tiefpassfilterverfahrens ist vorgesehen, das Differenzsignal vor der Begrenzung zu filter.

Außerdem besteht die Möglichkeit, das Differenzsignal zu gewichten und das gewichtete Differenzsignal zu dem ersten tiefpassgefiltertem Signal und dem begrenzten Differenzsignal hinzuzuaddieren, um ein tiefpassgefiltertes Ausgangssignal zu erzeugen.

Eine erfindungsgemäße Hochpassfilteranordnung zur Filterung eines eine Folge von Signalwerten aufweisenden Eingangssignals umfasst einen Eingang zur Zuführung des Eingangssignals und einen Ausgang zur Bereitstellung eines Filterausgangssignals, sowie ein erstes und ein zweites Hochpassfilter, die jeweils dem Eingang nachgeschaltet sind. Außerdem umfasst die Hochpassfilteranordnung eine Coring-Einheit mit einem Signaleingang, dem ein von einem Filterausgangssignal des ersten Hochpassfilters abhängiges Signal zugeführt ist, einem Steuereingang, dem ein von einem Signal am Ausgang des zweiten Hochpassfilters abhängiges Signal zugeführt ist, und mit einem Ausgang, der an den Ausgang der Hochpassfilteranordnung gekoppelt ist.

Diese erfindungsgemäße Hochpassfilteranordnung filtert das Eingangssignal adaptiv, in dem der Parameter der Coring-Einheit jeweils abhängig von dem Filterausgangssignal des zweiten Hochpassfilters eingestellt wird, wobei diesem zweiten Hochpassfilter das Eingangssignal zugeführt ist.

Vorzugsweise ist zwischen dem Ausgang des zweiten Hochpassfilters und den Steuereingang der Coring-Einheit eine Anordnung zur Betragsbildung des Filterausgangssignals des zweiten Hochpassfilters geschaltet. Optional ist außerdem eine Verstärkeranordnung zwischen das zweite Hochpassfilter und den Steuereingang der Coring-Einheit geschaltet, die vorzugsweise eine Verstärkung zwischen 0 und 1 aufweist und die dadurch eine Möglichkeit zur Einstellung des Filterverhaltens bietet.

Das erste Hochpassfilter besitzt vorzugsweise eine Übertragungsfunktion für die gilt:

$$H1\,(z) = k1 \cdot [-z^{-2}+2z^{-1}-1],$$

wobei k1 eine Konstante ist. Ein derartiges Filter verarbeitet drei aufeinanderfolgende Signalwerte des Eingangssignals und stellt am Ausgang einen gefilterten Wert zur Verfügung, der proportional ist zur Differenz zwischen dem mittleren der drei Signalwerte und dem Mittelwert der beiden anderen Signalwerte.

Für die Übertragungsfunktion des zweiten Hochpassfilters gilt vorzugsweise

$$H2\,(z) = k2 \cdot [z^{-2}-1],$$

wobei k2 eine Konstante ist. Ein Hochpassfilter mit einer derartigen Übertragungsfunktion verarbeitet drei aufeinander folgende Signalwerte und stellt einen Filterwert zur Verfügung, der proportional ist, zu einer Differenz zwischen dem ersten und dritten der drei aufeinander folgenden Eingangssignalwerte. Dieser Filtersignalwert entspricht bezugnehmend auf das zuvor erläuterte erfindungsgemäße Verfahren dem Intervall zwischen dem zweiten und dritten Signalwert.

Die Coring-Einheit dient bekanntlich dazu, Eingangssignalwerte, die innerhalb eines durch ein Steuersignal vorgegebenen Intervalls liegen, zu Null zu setzen und Werte, die kleiner oder größer als dieses Intervall sind, abhängig davon, ob der Eingangssignalwert größer als die durch das Steuersignal vorgegebene obere Intervallgrenze oder kleiner als die durch den Steuersignalwert vorgegebene untere Intervallgrenze liegt, um den Steuersignalwert zu verkleinern oder zu vergrößern.

Bei Verwendung zweier Hochpassfilter mit den oben erläuterten Übertragungsfunktionen ist das Steuersignal das den Coring-Parameter der Coring-Einheit darstellt, damit abhängig von der Intervallbreite zwischen dem zweiten und dritten Signalwert, wobei dieses Steuersignal angewendet wird auf ein Signal das der Differenz zwischen einem ersten Signalwert und dem Mittelwert zwischen dem zweiten und dritten Signalwert entspricht. Vorzugsweise ist zwischen den Ausgang der Coring-Einheit und den Ausgang der Filtereinrichtung eine Einrichtung geschaltet, die eine von außen einstellbare Verstärkung oder Dämpfung des Ausgangssignals der Coring-Einheit bewirkt.

Vorzugsweise ist zwischen den Ausgang der Coring-Einheit und den Ausgang der Filteranordnung eine Begrenzungsanordnung geschaltet.

Die erfindungsgemäße Hochpassfilteranordnung eignet sich zur Verwendung in einer Tiefpassfilteranordnung, in der ein Eingangssignal mittels einer Verknüpfungsschaltung mit dem Ausgangssignal der Hochpassfilteranordnung zur Bildung eines tiefpassgefilterten Signals verknüpft ist.

Die vorliegende Erfindung wird nachfolgend in Ausführungsbeispielen anhand von Figuren näher erläutert. In den Figuren zeigt

Figur 1  drei aufeinanderfolgende Signalwerte eines zu filternden Signals zur Erläuterung des erfindungsgemäßen Verfahrens,

Figur 2  drei weitere aufeinanderfolgende Signalwerte eines zu filternden Signals zur Erläuterung des erfindungsgemäßen Verfahrens,

Figur 3  ein zu filterndes alternierendes Signal und ein daraus resultierendes erfindungsgemäß gefiltertes Signal,

Figur 4  ein Sprungsignal und ein daraus resultierendes gefiltertes Signal (Figur 4a) und ein Impulssignal und ein daraus resultierendes gefiltertes Signal (Figur 4b),

Figur 5 ein Ausführungsbeispiel eines erfindungsgemäßen Hochpassfilters,

Figur 6 ein Ausführungsbeispiel einer Tiefpassfilteranordnung mit einem erfindungsgemäßen Hochpassfilter,

Figur 7 das Tiefpassfilter gemäß Figur 6 mit einer detaillierten Darstellung der Komponenten des Hochpassfilters,

Figur 8 einen beispielhaften Verlauf des Eingangssignals (Figur 8a) und des Ausgangssignals (Figur 8b) der Filteranordnung gemäß Figur 7,

Figur 9 einen beispielhaften zeitlichen Verlauf des Filtereingangssignals des Filters gemäß Figur 7, das Filterausgangssignal bei einer Hochpassfilterung nur jedes zweiten (geraden) Eingangswertes (Figur 9b) und das Filterausgangssignal bei Hochpassfilterung nur jedes zweiten (ungeraden) Eingangswertes (Figur 9c),

Figur 10 ein weiteres Ausführungsbeispiel eines Tiefpassfilters mit einer erfindungsgemäßen Hochpassfilteranordnung, wobei das hochpassgefilterte Signal am Ausgang des Hochpassfilters begrenzt wird,

Figur 11 ein weiteres Ausführungsbeispiel einer Tiefpassfilteranordnung mit einem erfindungsgemäßen Hochpassfilter,

Figur 12 ein weiteres Ausführungsbeispiel einer Tiefpassfilteranordnung mit einem erfindungsgemäßen Hochpassfilter,

Figur 13 ein weiteres Ausführungsbeispiel einer Tiefpassfilteranordnung mit einem erfindungsgemäßen Hochpassfilter,

Figur 14 eine Filtersystem mit einer Hintereinanderschaltung einer Tiefpassfilteranordnung und einer Hochpassfilteranordnung und beispielhafte zeitliche Verläufe einiger in dem System auftretender Signale,

Figur 15 eine Abwandlung der Filtervorrichtung nach Figur 7 zur Anwendung des erfindungsgemäßen Verfahrens auf beliebige, nicht notwendigerweise zeitlich oder räumlich aufeinanderfolgende Signalwerte,

Figur 16 eine schematische Darstellung einer Halbbildfolge zur Erläuterung der Anwendung des Verfahrens auf eine Bildpunktinterpolation,

Figur 17 eine schematische Darstellung einer Bildfolge und eines unter Verwendung von Bewegungsvektoren zu interpolierenden Zwischenbildes zur Erläuterung der Anwendung des Verfahrens auf eine bewegungsvektorgestützte Bildpunktinterpolation,

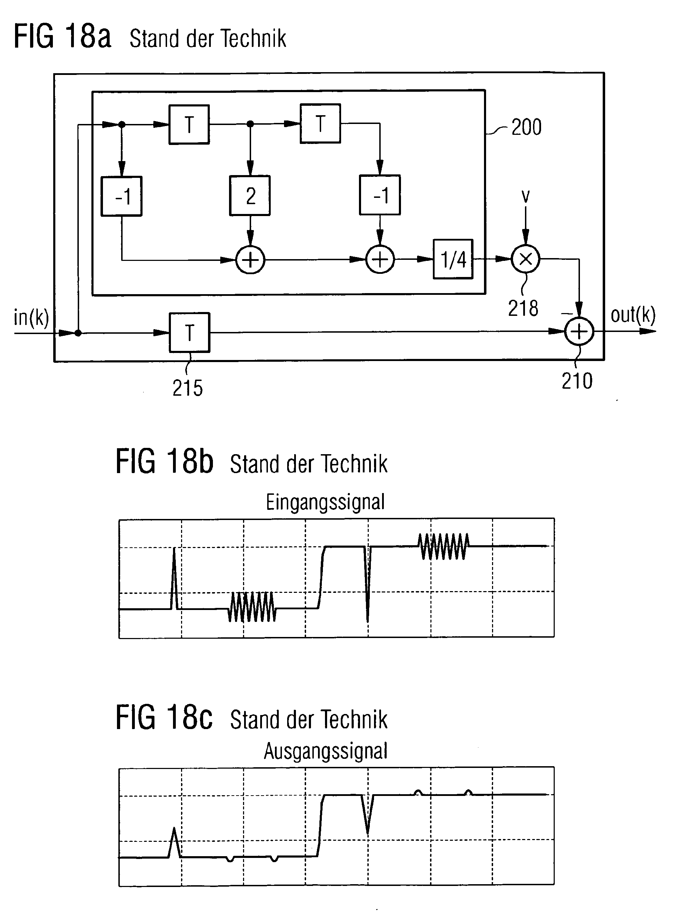

Figur 18 eine Filtersystem nach dem Stand der Technik (Figur 15a) sowie ein beispielhaftes Filtereingangssignal und ein zugehöriges Filterausgangssignal (Figur 15b, c),

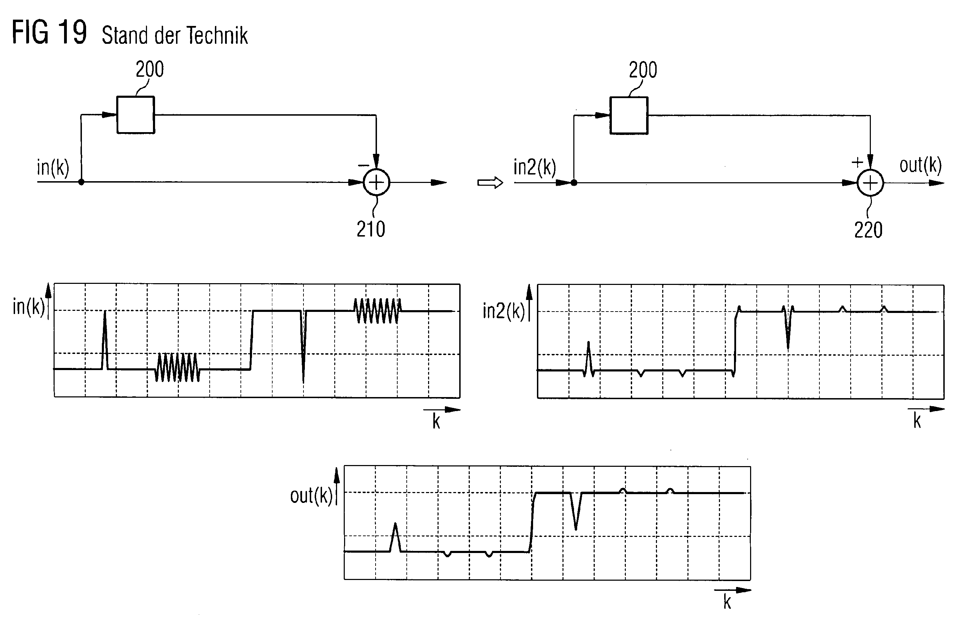

Figur 19 eine Filteranordnung mit einer Hintereinanderschaltung eines Tiefpassfilters und eines Hochpassfilters nach dem Stand der Technik.

In den Figuren bezeichnen, sofern nicht anders angegeben, gleiche Bezugszeichen gleiche Teile und Signale mit gleicher Bedeutung.

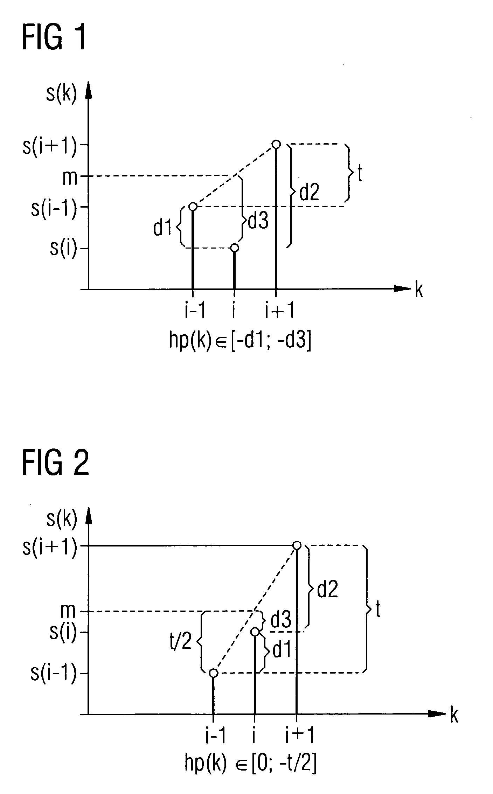

Das erfindungsgemäße Verfahren zur Filterung eines eine Folge von Signalwerten aufweisenden Signals s(k) zur Erzeugung eines ebenfalls eine Folge von Signalwerten aufweisenden gefilterten Signals hp (k) wird nachfolgend für die Erzeugung jeweils eines Signalwertes hp(i) des gefilterten Signals hp(k) anhand der Figuren 1 und 2 erläutert. k bezeichnet im Folgenden jeweils die Laufvariable der diskreten jeweils eine Folge von Signalwerten umfassenden Signale s(k), hp (k), i bezeichnet im Folgenden ein beliebiges Element dieser Laufvariable.

Das zu filternde Signal s(k) kann ein beliebiges, eine Folge von Signalwerten aufweisendes Signal, insbesondere ein zeitdiskretes Signal sein und somit Abtastimpulse eines zeitkontinuierlichen Signals darstellen. Die Folge von Signalwerten s(k) auch eine Folge von Bildinformationswerten repräsentieren, die spaltenweise oder zeilenweise aus einem Bild ausgelesen sind.

Das erfindungsgemäße Verfahren sieht zur Bereitstellung eines Signalwertes hp (i) des gefilterten Signals vor, einen Signalwert des zu filternden Signals s(k) auszuwählen, der in den Figuren 1 und 2 durch den Signalwert s(i) repräsentiert ist. Des Weiteren wird wenigstens ein dem ausgewählten ersten Signalwert s(i) vorausgehender zweiter Signalwert, der durch den Signalwert s(i-1) repräsentiert wird, und wenigstens ein dem ausgewählten Signalwert s(i) nachfolgender Signalwert auszuwählen, der in den Figuren 1 und 2 durch den Signalwert s(i+1) repräsentiert ist. Der zweite und dritte Signalwert s(i-1), s(i+1) spannen ein Intervall I = [s(i-1); s(i+1)] auf, dessen Breite in den Figuren 1 und 2 mit t bezeichnet ist.

Neben diesem Intervall wird der Mittelwert des ersten und zweiten Signalwertes s(i-1), s(i+1) ermittelt, der in den Figuren 1 und 2 mit m bezeichnet ist.

Dabei wird ermittelt, ob der erste Signalwert s(i) innerhalb des durch den zweiten und dritten Signalwert s(i-1), s(i+1) vorgegebenen Intervalls liegt. Wenn ja (siehe Figur 1), wird ein erster Abstand d1 zwischen dem ersten Signalwert s(i) und dem zweiten Signalwert s(i-1), ein zweiter Abstand d2 zwischen dem ersten Signalwert s(i) und dem dritten Signalwert s(i+1) sowie ein dritter Abstand zwischen dem ersten Signalwert s(i) und der Intervallmitte bzw. dem Mittelwert m ermittelt. Der gefilterte Signalwert hp(i) wird dann aus einem Intervall ausgewählt, das durch den kleineren des ersten und zweiten Abstands d1, d2 und den dritten Abstand d3 aufgespannt wird, wobei das Vorzeichen des gefilterten Signalwertes abhängig von der Lage des ersten Signalwertes s(i) bezogen auf den Mittelwert m derart ausgewählt wird, dass das Vorzeichen des gefilterten Signalwertes hp(i) negativ ist, wenn der erste Signalwert s(i) kleiner als der Mittelwert m ist, wie dies in Figur 1 dargestellt ist, und wobei das Vorzeichen des gefilterten Signalwertes hp(i) positiv ist, wenn der erste Signalwert s(i) größer als der Mittelwert m ist.

Das Auswählen des jeweils kleineren von dem ersten und zweiten Abstand d1, d2 führt dazu, dass der Betrag des gefilterten Wertes hp(i) in einem Intervall liegt, das durch den Abstand zur nächstliegenden Intervallgrenze und dem Abstand zur Intervallmitte gebildet wird. In dem Beispiel gemäß Figur 1 bildet der zweite Signalwert s(i-1) die nächstliegende Intervallgrenze zu dem Signalwert s(i).

Sofern der ausgewählte Signalwert s(i) innerhalb des durch den zweiten Signalwert s(i-1) und den dritten Signalwert s(i+1) aufgespannten Intervalls der Breite t liegt, wird für den gefilterten Signalwert hp(i) ein Signalwert ausgewählt, der innerhalb eines Intervalls von Null bis zur Hälfte der Intervallbreite t/2 reicht, wobei das Vorzeichen des gefilterten Signalwerts hp(i) negativ ist, wenn der erste Signalwert kleiner als der Mittelwert m ist, und positiv ist, wenn der erste Signalwert s(i) größer als der Mittelwert m ist.

Aus dem oben Gesagten folgt für den Fall, in dem der zweite und dritte Signalwert s(i-1), s(i+1) gleich groß, der erste Signalwert s(i) jedoch größer oder kleiner als die beiden anderen Signalwerte ist, das als gefilterter Signalwert hp(i) ein Wert ausgegeben wird, dessen Betrag der Differenz zwischen dem ersten Signalwert s(i) und einem der beiden anderen Signalwerte s(i-1), s(i+1) entspricht und dessen Vorzeichen abhängig davon gewählt ist, ob der erste Signalwert s(i) größer oder kleiner als die beiden anderen Signalwerte ist.

Für den Fall, dass der erste, zweite und dritte Signalwert gleich groß sind, ist der gefilterte Signalwert hp(i) gleich Null.

Um Rauscheinflüsse zu unterdrücken ist vorzugsweise vorgesehen, die bei Durchführung des Verfahrens ermittelten ersten bis dritten Abstände und die Intervallbreite jeweils zu Null zu setzen, sofern der ermittelte Wert kleiner als ein vorgegebener Grenzwert ist, da davon ausgegangen werden muss, dass nur geringfügige Abweichungen der betrachteten Signalwerte aus unerwünschten Rauscheinflüssen resultieren.

Vorzugsweise wird bei dem erfindungsgemäßen Verfahren als gefilterter Signalwert hp(i) ein Wert ausgegeben, dessen Betrag dem Abstand zwischen dem ersten Signalwert s(i) und der nächstliegenden Intervallgrenze entspricht und dessen Vorzeichen abhängig von der Lage des ersten Signalwertes s(i) bezogen auf den Mittelwert m gewählt ist, wenn der erste Signalwert s(i) außerhalb des durch den zweiten und dritten Signalwert aufgespannten Intervalls liegt. Vorzugsweise wird weiterhin der gefilterte Signalwert hp(i) zu Null gesetzt, wenn der erste Signalwert s(i) innerhalb des durch den zweiten und dritten Signalwerts s(i-1), s(i+1) aufgespannten Intervalls liegt. Bei dieser speziellen Ausgestaltung des Verfahrens ist der gefilterte Signalwert hp(i) gleich Null, wenn der erste Signalwert s(i) dem zweiten oder dritten Signalwert s(i-1), s(i+1) entspricht.

Zu Zwecken der Erläuterung wurde bislang davon ausgegangen, dass die das Intervall aufspannenden zweiten und dritten Signalwerte sind, die in der Signalfolge unmittelbar vor und unmittelbar nach dem betrachteten Signalwert s(i) liegen, wobei diese zweiten und dritten Signalwerte die Intervallgrenzen des Intervalls bilden, das bei der Erzeugung des gefilterten Signalwertes hp(i) betrachtet wird.

Es besteht jedoch auch die Möglichkeit, mehrere zweite, dem betrachteten Signalwert s(i) vorausgehende Signalwerte und mehrere dem betrachteten Signalwert s(i) nachfolgende dritte Signalwerte auszuwählen und zwischen jedem der zweiten Signalwerte und jedem der dritten Signalwerte ein Intervall zu bilden und den ersten Signalwert und den dritten Signalwert aufzuwählen, die das größte Intervall aufspannen, wobei dieser zweite und dieser dritte Signalwert dann die Intervallgrenzen des im Weiteren betrachteten Intervalls bilden.

Mathematisch kann der durch die Filterung erzeugte Signalwert hp(k) für den Fall, in dem der erste Signalwert s(i) außerhalb des durch den zweiten und dritten Signalwert s(i-1), s(i+1) gebildeten Intervalls liegt, dadurch gebildet werden, dass die Differenz zwischen dem ersten Signalwert s(i) und dem Mittelwert m gebildet wird, und der Betrag der halben Intervallbreite von der dadurch erhaltenen Differenz subtrahiert wird, wenn der Signalwert s(i) größer als die obere Intervallgrenze ist, und der Betrag der halben Intervallbreite zu der dadurch erhaltenen Differenz hinzuaddiert wird, wenn der Signalwert s(i) kleiner als die untere Intervallgrenze ist. Liegt s(i) oberhalb der oberen Intervallgrenze, so ist die ermittelte Differenz zwischen dem Signalwert s(i) und der halben Intervallgrenze positiv, wobei der Wert, der durch Subtrahieren der halben Intervallbreite von diesem Differenzwert erhalten wird, vorzugsweise nach unten hin zu Null begrenzt wird. Liegt s(i) unterhalb der unteren Intervallgrenze, so ist die ermittelte Differenz zwischen dem Signalwert s(i) und der halben Intervallgrenze negativ, wobei der Wert, der durch Addieren dieses Differenzwertes zu der halben Intervallbreite erhalten wird, vorzugsweise nach oben hin zu Null begrenzt wird. Auch für dieses spezielle Vorgehen zur Ermittlung eines gefilterten Wertes hp(k) gilt, dass sowohl die Differenz, als auch die halbe Intervallbreite vorzugsweise zu Null gesetzt werden, wenn der für diese Differenz oder die halbe Intervallbreite ermittelte Wert kleiner als ein vorgegebener Grenzwert ist.

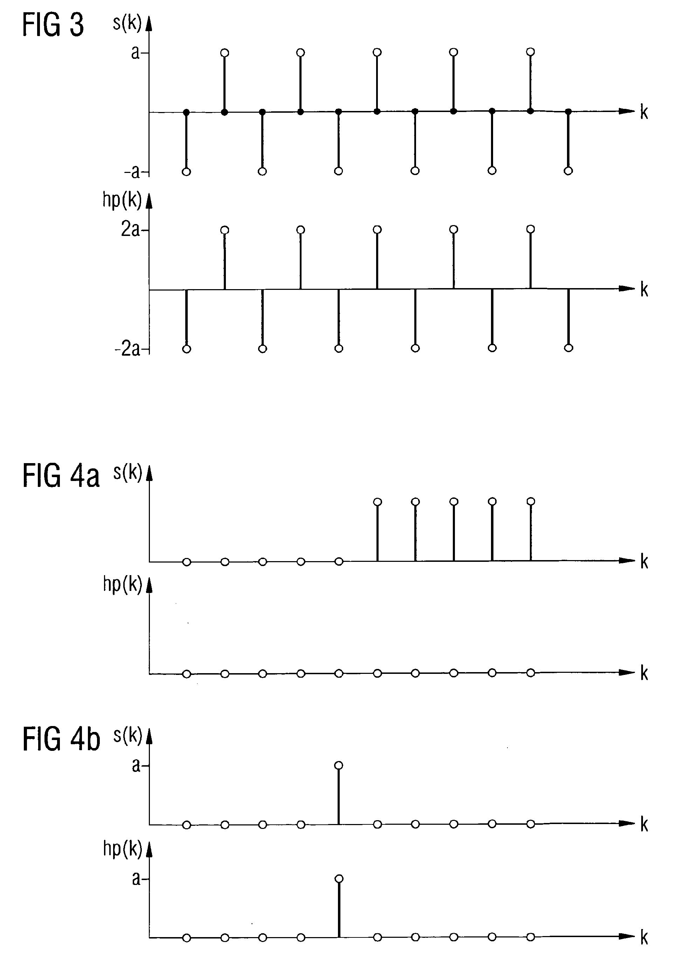

Figur 3 veranschaulicht die Wirkungsweise des erfindungsgemäßen Verfahrens bei Filterung eines alternierenden Signals s(k), das abwechselnd Signalwerte von -a und +a annimmt, für die spezielle Ausgestaltung des Verfahrens, bei der jeweilige Filtersignalwert dem Abstand zur nächstliegenden Intervallgrenze entspricht, wenn der erste Signalwert außerhalb des durch den zweiten und dritten Signalwert gebildeten Intervalls liegt, und bei dem der Filtersignalwert zu Null gesetzt wird, wenn der erste Signalwert innerhalb des Intervalls liegt. Das hieraus resultierende Hochpasssignal hp(k) ist ebenfalls ein alternierendes Signal, das abwechselnd negative Signalwerte mit einer Amplitude -2a und positive Signalwerte mit einer Amplitude von +2a annimmt, das gefilterte Signal entspricht somit dem Eingangssignal mit doppelter Amplitude.

Der besondere Vorteil der erfindungsgemäßen Verfahrens wird anhand von Figur 4a deutlich, in der ein Sprungsignal s(k) dargestellt ist, das zunächst eine Folge konstanter aufeinander folgender Werte (in dem Beispiel mit Amplitude Null) und nach einem sprungartigen Wechsel eine konstante Folge von Signalwerten mit einer Amplitude ungleich Null aufweist. Das hieraus resultierende Hochpasssignal hp(k), das dadurch gebildet wurde, dass zu einem Signalwert jeweils der Abstand zur nächsten Intervallgrenze eines durch den vorangehenden und den nachfolgenden Signalwert gebildeten Intervalls ermittelt wurde, "ignoriert" dieses Sprung und stellt sich als konstantes Signal mit der Amplitude Null dar.

Figur 4b veranschaulicht das erfindungsgemäße Hochpassfilterverfahren anhand eines einen Impuls der Amplitude a aufweisenden Signals s(k), wobei das gefilterte Signal hp(k) ebenfalls einen Impuls der Amplitude a enthält.

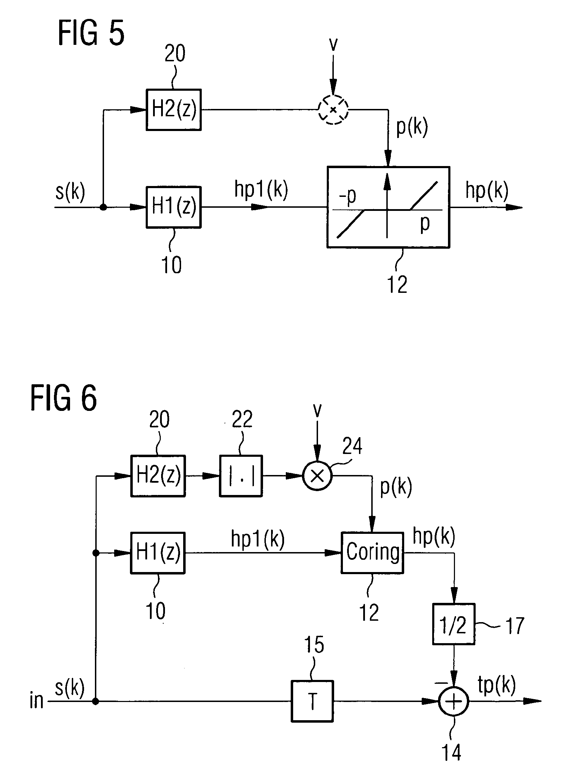

Figur 5 zeigt ein Ausführungsbeispiel eines erfindungsgemäßen Hochpassfilters zur Durchführung des erfindungsgemäßen Verfahrens. Diese Hochpassfilteranordnung umfasst ein erstes Hochpassfilter 10 mit einer Übertragungsfunktion H1(z) und ein zweites Hochpassfilter 20 mit einer Übertragungsfunktion H2(z), denen jeweils das am Eingang der Hochpassfilteranordnung anliegende zu filternde Signal s(k) zugeführt ist. Dem ersten und zweiten Filter 10, 20 ist eine Coring-Einheit 12 nachgeschaltet, die einen Signaleingang zum Zuführen eines zu verarbeitenden Signals und einen Steuereingang aufweist. Dem Steuereingang dieser Coring-Einheit 12 ist ein Ausgangssignal p(k) des zweiten Hochpassfilters 20 zugeführt und dem Signaleingang der Coring-Einheit 12 ist ein Ausgangssignal hp1 (k) des ersten Filters 10 zugeführt. Am Ausgang der Coring-Einheit steht das hochpassgefilterte Signal hp(k) zur Verfügung. Das Ausgangssignal des zweiten Hochpassfilters kann optional einer Betragsbildung unterworfen werden, bevor es der Coring-Einheit zugeführt wird.

Die Funktionsweise einer Coring-Einheit ist hinlänglich bekannt und wird im Folgenden nur kurz zusammen gefasst. Ein durch die Coring-Einheit 12 gelieferter Ausgangssignalwert hp(i) ist Null, wenn der Eingangssignalwert hp1 (i) innerhalb eines durch -p(i) und +p(i) vorgegebenen Intervalls liegt. Ist der Eingangssignalwert hp1 (i) größer als p(1), so wird als Ausgangssignalwert hp(i) die Differenz zwischen dem Eingangssignalwert und dem Steuersignalwert p(i) ausgegeben. Ist der Eingangssignalwert hp1 (i) kleiner als der negative Steuersignalwert -p(i) so wird als Ausgangssignalwert hp(i) die Summe aus dem Eingangssignalwert hp1 (i) und dem Steuersignalwert p(i) ausgegeben.

Die Übertragungsfunktion H1 (z) des ersten Hochpassfilters ist vorzugsweise:

$$H1\ (z) = 0,5 \cdot [-z^{-2} + 2 \cdot z^{-1} - 1].$$

Bezogen auf die diskrete Eingangsfolge s(k) bedeutet dies, dass ein Signalwert hp1 (i) am Ausgang des ersten Filters 10 proportional ist zu einer Differenz zwischen einem Signalwert s(i) und dem Mittelwert des vorausgehenden Wertes s(i-1) und nachfolgenden Wertes s(i+1). Für die Übertragungsfunktion H2(z) des zweiten Filters 20 gilt vorzugsweise:

$$H2\ (z) = 0,5 \cdot [1 - z^{-2}] \qquad (1).$$

Bezogen auf das diskrete Signal s(k) bedeutet dies, dass das als Parametersignal für die Coring-Einheit 12 verwendete Signal für einen Signalwert s(i) des diskreten Signals s(k) jeweils die halbe Intervallbreite eines durch den diesem Wert s(i) vorausgehenden Signalwert s(i-1) und eines diesem Wert nachfolgenden Signalwertes s(i+1) aufgespannten Intervalls darstellt. Das Ausgangssignal der Coring-Einheit 12 wird vorzugsweise einer Verstärkung oder Dämpfung unterzogen, bevor es dem Ausgang des Filters zugeführt wird.

Bei dieser Filteranordnung wird somit ein Filterausgangswert von Null ausgegeben, wenn die Differenz zwischen einem Signalwert und dem Mittelwert der benachbarten Signalwerte kleiner als die halbe Intervallbreite ist, wenn dieser Wert also innerhalb des durch die benachbarten Signalwerte aufgespannten Intervalls liegt. Ist die Differenz zwischen dem Signalwert und dem Mittelwert der benachbarten Signalwerte größer als die halbe durch p(k) repräsentierte Intervallbreite, so wird ein Filtersignalwert ausgegeben, der der Differenz zwischen dem Signalwert und dem Mittelwert plus oder minus der halben Intervallbreite entspricht, und der somit den Abstand zwischen dem Signalwert und der nächstliegenden Intervallgrenze des durch die benachbarten Signalwerte aufgespannten Intervalls repräsentiert.

Wie in Figur 5 gestrichelt dargestellt ist, ist dem zweiten Hochpassfilter 20 optional ein Verstärker nachgeschaltet, der das Ausgangssignal des zweiten Filters mit einem Verstärkungsfaktor v multipliziert, wobei dieser Verstärkungsfaktor v der vorzugsweise im Bereich zwischen Null und Eins liegt.

Mittels dieses Verstärkungsfaktors v lässt sich die Amplitude des hochpassgefilterten Signals hp(k) variieren, wobei ein Verstärkungsfaktor von Null dem Fall entspricht, bei dem die Coring-Einheit das am Ausgang des ersten Filters 10 anliegende Signal unverändert an den Ausgang durchlässt, wobei die einzelnen Signalwerte bei Berücksichtigung der oben genannten Übertragungsfunktion des ersten Filters dann jeweils der Differenz zwischen einem Signalwert und dem Mittelwert der benachbarten Signalwerte entspricht.

Das erfindungsgemäße Hochpassfilter gemäß Figur 5 eignet sich insbesondere zur Verwendung in einem Tiefpassfilter, das in Figur 6 dargestellt ist. Dieses Tiefpassfilter umfasst neben dem erfindungsgemäßen Hochpassfilter lediglich einen Subtrahierer 14, dessen nicht-invertierendem Eingang das zu filternde Eingangssignal s(k) und dessen invertierendem Eingang das hochpassgefilterte Signal hp(k) zugeführt ist. Dem nichtinvertierenden Eingang des Subtrahierers ist zudem ein Laufzeitglied vorgeschaltet, um das zu filternde Signal s(k) entsprechend der Verzögerungen in dem Hochpassfilter zu verzögern.

Das Hochpassfiltersignal hp(k) wird in der Tiefpassfilteranordnung gemäß Figur 6 vor der Subtraktion von dem verzögerten Eingangssignals s(k) mit einem Multiplikationsfaktor 0,5 mittels einer Gewichtungsanordnung 17 gewichtet.

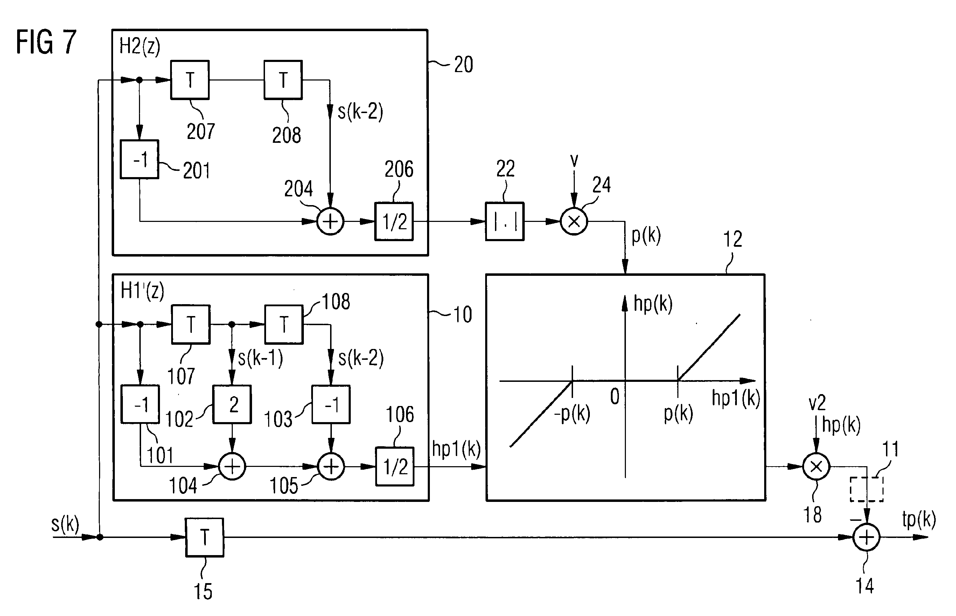

Figur 7 zeigt die in Figur 6 dargestellte Tiefpassfilteranordnung mit im Detail dargestellten ersten und zweiten Hochpassfiltern 10, 20. Das erste Hochpassfilter 10 besitzt dabei eine Übertragungsfunktion H1 (z) für die gilt:

$$H1\ (z) = 0,5 \cdot [-z^{-2} - 2z^{-1} -1] \qquad (2)$$

und ist als FIR-Filter mit einer hinlänglich bekannten nicht rekursiven Struktur aus Gewichtungselementen 101, 102, 103 Verzögerungselementen 107, 108, Addierern 104, 105 und einem dem Filterausgang vorgeschalteten weiteren Verstärkungselement 106 aufgebaut.

Das zweite Tiefpassfilter 20 besitzt die bereits oben erläuterte Übertragungsfunktion H2(z), wobei auch dieses Filter als FIR-Filter aus einer nicht-rekursiven Struktur aufgebaut ist, die ein Gewichtungselement 201, Verzögerungselemente 207, 208 einen Addierer 204 und ein dem Ausgang des Hochpassfilters 20 vorgeschaltetes Gewichtungselement 206 aufweist. Für eine Übertragungsfunktion P(z), die die Abbildung des Eingangssignals p(k) auf das der Coring-Einheit zugeführte Signal p(k) im Frequenzbereich definiert, gilt dann:

$$P(z) = v \cdot |0,5 \cdot (z^{-2}-1)\ | \qquad (3),$$

wobei v der Verstärkungsfaktor des Verstärkers 24 ist, wobei dieser Verstärkungsfaktor vorzugsweise 1 ist.

In Figur 7 ist weiterhin die Funktionsweise der Coring-Einheit 12 anhand der Übertragungskennlinie dieser Coring-Einheit unter Verwendung des am Steuereingang der Steuer-Einheit 12 anliegenden Signals p(k), das aus dem Filterausgangssignal des zweiten Hochpassfilters 20 durch Betragsbildung und Gewichtung resultiert, sowie anhand des Filterausgangssignals hp1 (k) des ersten Hochpassfilters 10 und anhand des am Ausgang der Coring-Einheit anliegenden hochpassgefilterten Signals hp(k) dargestellt. Die Kennlinie macht deutlich, dass das Eingangssignal hpl für Wertebereiche zwischen -p(k) und +p(k) zu Null gesetzt wird, für Wertebereiche größer als p(k) aus der Differenz von hp1 (k) und p(k) resultiert und für Werte kleiner -p (k) aus der Summe von hp1 (k) und p(k) resultiert.

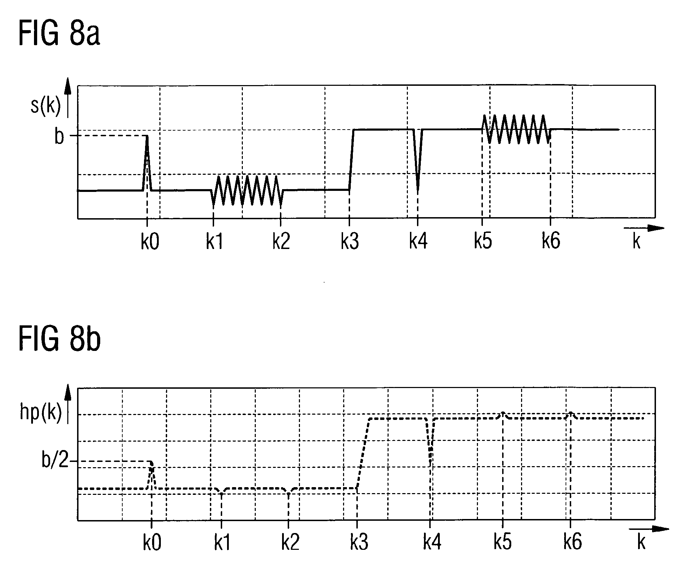

Figur 8a zeigt beispielhaft ein mögliches der Tiefpassfilteranordnung gemäß Figur 7 zugeführtes Eingangssignal s(k). Figur 8B zeigt das aus diesem Eingangssignal gemäß Figur 8 resultierende tiefpassgefilterte Signal tp(k) am Ausgang der Filteranordnung gemäß Figur 7. Zum besseren Verständnis sind in Figur 8 Punkte im Verlauf des Eingangssignals s(k), an denen auffällige Änderungen des Signals auftreten durch Laufvariablen k(0) bis k(6) hervorgehoben. Unter Vernachlässigung von Laufzeitverzögerungen der Tiefpassfilteranordnung sind entsprechende Laufvariablen k(0) bis k (6) in Figur 8b dargestellt, um die Auswirkungen der Tiefpassfilterung auf die Stellen mit markanten Signalveränderungen hervorzuheben.

Das Eingangssignal s(k) ist in dem dargestellten Ausschnitt ein Sprungsignal mit einem Sprung von einem unteren Niveau auf ein oberes Niveau bei k3, wobei bei diesem Sprungsignal bei k0 ein positiver Impuls und bei k4 ein negativer Impuls sowie zwischen k1 und k3 und k5 und k6 ein hochfrequenter Signalanteil überlagert ist.

Wie dem Signalverlauf des tiefpassgefilterten Signals tp(k) zu entnehmen ist, lässt das Tiefpassfilter den Sprung sowie das untere Niveau und das obere Niveau der Sprungfunktion unverändert, da in der erläuterten Weise das hochpassgefilterte Signal hp(k) bei konstanten Werten des Eingangssignals und bei einem Sprung des Eingangssignals von einem unteren konstanten Wert auf einen oberen konstanten Wert einen Signalwert von Null aufweist. Die Impulse bei k0 und k4 bleiben grundsätzlich erhalten, werden jedoch in ihrer Amplitude bezogen auf das Grundniveau, das bei dem Impuls bei k0 das untere Niveau des Sprungsignals, und bei dem Impuls bei k4 das obere Niveau des Sprungsignals darstellt, halbiert, da in der bereits erläuterten Weise, die Hochpassfilteranordnung auf einen Impuls ebenfalls mit einem Impuls reagiert, und dieser Impuls des hochpassgefilterten Signals Hochpasssignals hp(k) in Figur 7 mit einem Faktor 0,5 mit seiner halben Amplitude von dem Impuls des Eingangssignals s(k) abgezogen bzw. zu diesem hinzuaddiert wird.

Zur Variation der Amplitude der nach der Tiefpassfilterung tp(k) verbleibenden Impulse besteht optional die Möglichkeit, das am Ausgang der Coring-Einheit 12 anliegende hochpassgefilterte Signal mittels der in Figur 7 dargestellten Gewichtungsanordnung 18 zu gewichten, um das Ausgangssignal hp(k) des Hochpassfilters bereitzustellen, wobei dieser Gewichtungsfaktor v2 vorzugsweise in einem Intervall zwischen 0 und 1 liegt, wobei im Extremfall eines Wertes von Null das Eingangssignal s(k) unverändert, lediglich verzögert, als tiefpassgefiltertes Signal tp(k) ausgegeben wird. Im anderen Extremfall eines Gewichtungsfaktors v2 von 1 wird von dem Eingangssignal s(k) ein hochpassgefiltertes Signal subtrahiert, dessen Amplitude bei Impulsen genau der Amplitude der Impulse des Eingangssignals s(k) entspricht, so dass Impulse in dem tiefpassgefilterten Signal tp(k) vollständig ausgelöscht sind. Bei einem Verstärkungsfaktor v2=0,5 wird die Amplitude der Impulse halbiert. Zusammenfassend lässt das erfindungsgemäße Verfahren zur Hochpassfilterung Sprünge des Eingangssignals s(k) unverändert, wobei weiterhin über die Gewichtung des hochpassgefilterten Signals hp(k) vor der Subtraktion von dem Eingangssignal s(k) eingestellt werden kann, wie stark die Impulse des Eingangssignals s(k) in dem am Ausgang der Tiefpassfilteranordnung tp(k) anliegende tiefpassgefilterten Signal tp(k) gedämpft sein sollen.

Wie Figur 8b weiter zeigt, werden die hochfrequenten Signalanteile weitgehend ausgelöscht, wobei lediglich am Anfang und Ende des jeweiligen hochfrequenten Signalanteils Impulse erzeugt werden.

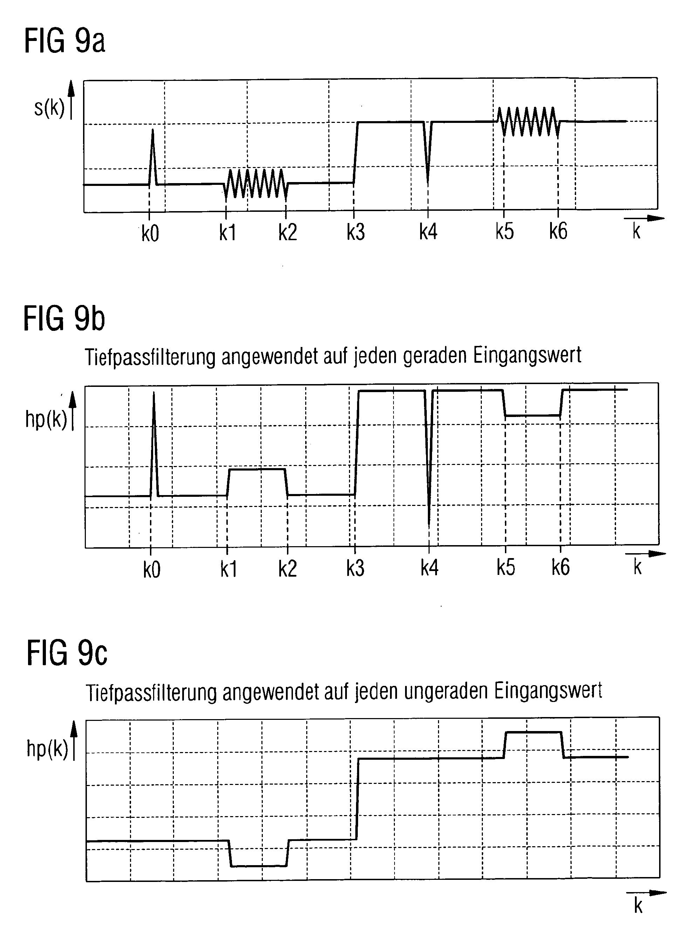

Figur 9 zeigt nochmals den Signalverlauf gemäß Figur 8a wobei dieser Signalverlauf in Figur 9 Signalverläufen in den Figuren 9b und 9c gegenüber gestellt ist, die dadurch erhalten wurden, dass von dem Eingangssignal s(k) bei der Filteranordnung gemäß Figur 7 nur jeweils jeder zweite am Ausgang der Coring-Einheit 12 anliegende hochpassgefilterte Wert subtrahiert wird. Zu diesem Zweck kann beispielsweise eine in Figur 7 gestreichelt eingezeichnete Abtasteinheit 11 vorgesehen sein, die der Coring-Einheit nachgeschaltet und dazu ausgebildet ist jeden zweiten Ausgangswert hp(k), also entweder die Werte mit geradzahliger Laufvariable k oder die Werte mit ungeradzahliger Laufvariable k, zu Null zu setzen. Hierdurch wird nur jeder zweite Wert des Eingangssignals s(k) tiefpassgefiltert, während die anderen Werte unverändert, lediglich zeitverzögert, an den Ausgang gelangen.

Das Abtastmuster kann abhängig vom Anwendungsfall jedoch beliebig variiert werden, indem beispielsweise nur jeder n-te Ausgangswert hp(k) zu Null gesetzt oder nur n-te Wert durchgelassen wird, wobei n ein ganzzahliger Wert ist.

Figur 9b zeigt dabei den Verlauf, der erhalten wird, wenn nur die Werte mit geradzahligen Indizes k tiefpassgefiltert werden, wobei die Impulse bei k0 und k4 in diesem abgetasteten, der Tiefpassfilterung unterworfenen Signal gerade nicht enthalten sind, und damit bei der Hochpassfilterung nicht berücksichtigt werden und somit im tiefpassgefilterten Signal tp(k) unverändert enthalten sind. Wie weiterhin deutlich wird, erzeugt diese Art der Filterung eine Einhüllende für die hochfrequenten Signalanteile zwischen k1, k2 und k5, k6.

Figur 9c zeigt das Filterergebnis für den Fall, bei dem alle Eingangssignalwerte s(k) mit ungeradzahligen Indizes tiefpassgefiltert werden, wobei diese gefilterten Signalwerte die Impulse bei k0 und k4 enthalten und diese Impulse in dem am Ausgang anliegenden tiefpassgefilterten Signal tp(k) vollständig ausgelöscht sind, sofern die Verstärkungsfaktoren v=1 und v2=1 sind, da das hochpassgefilterte Signal die Impulse. dann mit ihren vollen Amplitude enthält und diese Impulse vom Eingangssignal subtrahiert werden.

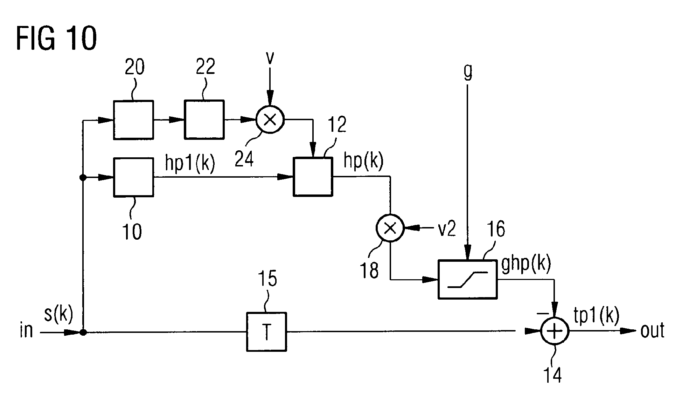

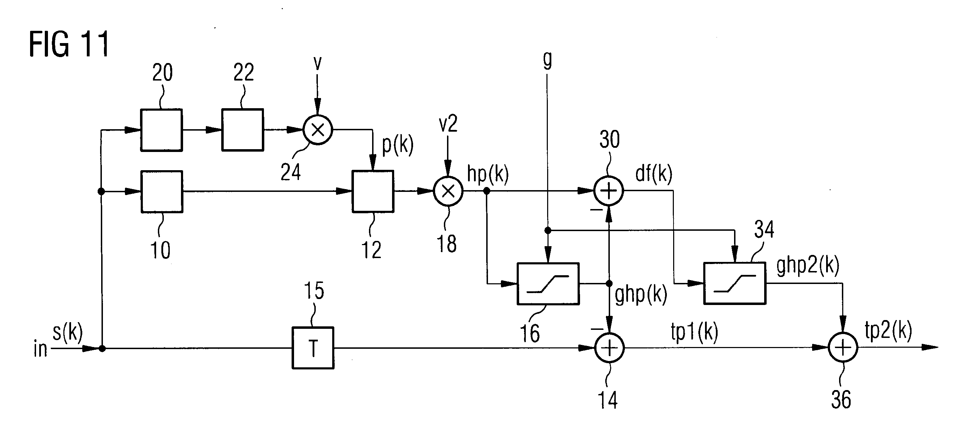

Figur 10 zeigt eine gegenüber den Figuren 6 und 7 abgewandelte Tiefpassfilteranordnung, die ein erfindungsgemäßen Hochpassfilter gemäß Figur 5 umfasst. Bei dieser Tiefpassfilteranordnung ist vorgesehen, dass am Ausgang der Hochpassfilteranordnung anliegende hochpassgefilterte Signal hp(k) mittels einer Begrenzungseinheit 16 zu begrenzen, bevor das hochpassgefilterte Signal hp(k) von dem verzögerten Eingangssignal s(k) subtrahiert wird. Das hochpassgefilterte Signal entspricht in Figur 10 und den nachfolgend noch erläuterten Figuren 11 bis 13 dem Ausgangssignal der Coring-Einheit 12, wenn auf die optionale Gewichtungseinheit 18 verzichtet ist, und dem mit dem Faktor v2 gewichteten Ausgangssignal der Coring-Einheit 12, wenn die Gewichtungseinheit 18 vorhanden ist. Der Gewichtungswert v2 liegt zwischen 0 und 1 und beträgt vorzugsweise 0,5, wenn Übertragungsfunktionen H1 (z), H2 (z) entsprechend obiger Gleichungen (1) und (2) verwendet werden.

Die Begrenzungseinheit 16 ist vorzugsweise dazu ausgelegt, das hochpassgefilterte Signal hp(k) symmetrisch auf einen oberen Grenzwert g bzw. einen unteren Grenzwert -g zu begrenzen, wobei dieser Grenzwert g von außen über einen Steuereingang der Begrenzungseinheit 16 einstellbar ist. Am Ausgang der Begrenzungseinheit 16 steht ein Signal ghp(k) zur Verfügung, das von dem verzögerten Eingangssignal s(k) subtrahiert wird. Die Begrenzungseinheit bewirkt, dass die von dem Eingangssignal s(k) subtrahierten Hochpasssignalwerte ghp(k) eine maximale Amplitude g aufweisen. Hochpasssignalanteile in dem Eingangssignal s(k), deren Amplituden innerhalb des Begrenzungsbereiches liegen, werden durch die Anordnung damit vollständig tiefpassgefiltert, während Signalanteile, deren Amplituden größer als der Begrenzungsbereich sind, nur um einen durch den Begrenzungsbereich vorgegebenen Wert in deren Amplitude reduziert werden. Insbesondere Rauscheinflüsse mit kleiner Amplitude können durch dieses Vorgehen ausgefiltert werden, wobei allerdings auch hochfrequente Nutzsignalanteile beeinflusst werden.

Figur 11 zeigt eine Abwandlung der Tiefpassfilteranordnung gemäß Figur 10, die sich von der Filteranordnung gemäß Figur 10 dadurch unterscheidet, dass das begrenzte hochpassgefilterte Signal ghp(k) mittels eines Subtrahierers 30 von dem hochpassgefilterten Signal hp(k) subtrahiert wird, um ein Differenzsignal df(k) zu erzeugen. Dieses Differenzsignal df(k) wird mittels eines weiteren Begrenzers 34, dem ebenfalls der Grenzwert g zugeführt ist, und der ein ihm zugeführtes Signal ebenfalls symmetrisch begrenzt, zugeführt. Das am Ausgang dieses Begrenzers 34 anliegende Signal ghp2(k) wird mittels eines weiteren Addierers 36 zu dem Ausgangssignal tp1 (k) des Subtrahierers 14, der von dem verzögerten Eingangssignal s(k) das begrenzte hochpassgefilterte Signal ghp(k) subtrahiert, hinzu addiert, um ein tiefpassgefiltertes Signal tp2(k) zur Verfügung zu stellen. Wie im Zusammenhang mit Figur 10 ausgeführt wurde, werden hochfrequente Signalanteile, die kleiner als der Begrenzungswert sind, vom Eingangssignal s(k) subtrahiert und damit tiefpassgefiltert, wobei jedoch auch hochfrequente Nutzsignalteile in ihrer Amplitude reduziert werden. Bei Anwendungen, deren Zielsetzung es ist, nur hochfrequente Rauschsignalanteile bis zu einer bestimmten Amplitude auszufiltern, ist diese Beeinflussung des Nutzsignals unerwünscht.

In der Anordnung gemäß Figur 11 wird für hochfrequente Signalanteile, die größer als der Begrenzungsbereich sind, ein Korrektursignal das mittels des Addierers 36 dem tiefpassgefilterten Signal wieder hinzugefügt wird. Hierzu wird zunächst das Differenzsignals df(k) gewonnen, wobei dieses Signal df(k) Null ist, so lange die Amplitude des Signals hp(k) kleiner als der Begrenzungswert g ist. Für Amplituden von hp(k) größer als der Begrenzungswert ergeben sich Amplituden des Differenzsignal df(k) größer als Null. Um zu vermeiden, dass zu dem durch Subtraktion des Eingangssignals s(k) und des Hochpasssignals hp(k) gewonnenen Signal tp1 (k) hochfrequente Signalanteile hinzuaddiert werden, deren Amplituden größer sind als die Amplituden dieser Signalanteile im Eingangssignal s(k) wird die Amplitude des Differenzsignals durch die Begrenzungseinheit 34 entsprechend dem Signal hp(k) in der Einheit 16 begrenzt. Hieraus resultiert ein Gesamtverhalten der Schaltung, das sich wie folgt beschreiben lässt:

-    für hochfrequente Signalanteile kleiner als der Begrenzungsbereich erfolgt eine Tiefpassfilterung,

-    für hochfrequente Signalanteile größer als der doppelte Begrenzungsbereich erfolgt keine Veränderung,

-    für hochfrequente Signalanteile größer als der Begrenzungsbereich und kleiner als der doppelte Begrenzungsbereich erfolgt ein allmählicher Übergang von der Tiefpassfilterung zu einem unbeeinflussten Durchlassen des Signals.

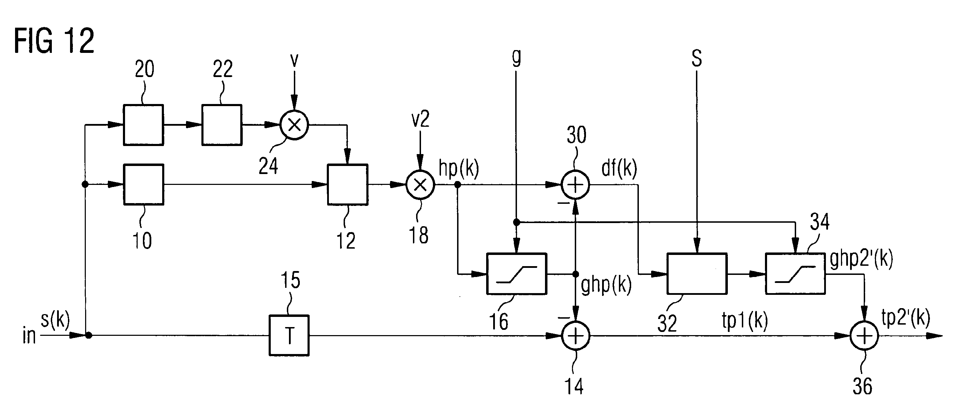

Figur 12 zeigt eine gegenüber Figur 11 abgewandelte Tiefpassfilteranordnung, die sich von der in Figur 11 dargestellten dadurch unterscheidet, dass der Begrenzungseinheit 34 ein Filter 32 zur Filterung des Differenzsignals df(k) vorgeschaltet ist, wobei das Übertragungsverhalten dieses Filters mittels eines externen Einstellwertes f eingestellt werden kann. Am Ausgang der Begrenzungseinheit 34 steht bei diesem Ausführungsbeispiel ein hochpassgefiltertes Signal ghp2' (k) zur Verfügung, das zu dem Ausgangssignal tp1 (k) des Subtrahierers addiert wird. Am Ausgang der Gesamtanordnung steht ein tiefpassgefiltertes Signal tp2' (k) zur Verfügung.

Das Filter 32 ermöglicht es, den zuvor erläuterten Übergangsbereich zwischen einer Tiefpassfilterung der hochfrequenten Signalanteile und deren unverändertem Durchlassen zu gestalten. Dieser Übergangsbereich kann schmaler werden, wenn das Filter 32 verstärkenden Charakter mit einem Verstärkungsfaktor größer als Eins besitzt, da dann bereits für kleinere Werte des Differenzsignal df(k) eine Begrenzung erfolgt.

Dieser Übergangsbereich kann auch breiter werden, wenn das Filter 32 verstärkenden Charakter mit einem Verstärkungsfaktor kleiner als Eins besitzt, da dann erst für größere Werte des Differenzsignals df(k) eine Begrenzung erfolgt.

Vorzugsweise besitzt das Filter 32 ein Übertragungsverhalten, durch das kleine Werte des Differenzsignals df(k) gedämpft, mittlere Werte verstärkt und große Werte, vorzugsweise Werte, die nur etwas kleiner als der Begrenzungswert sind, wiederum gedämpft werden, um einen gleitenden Übergang zwischen dem Tiefpassverhalten und dem Durchlassverhalten einzustellen. Das Filter kann eine Nachschlagetabelle enthalten, durch die den Amplituden des Differenzsignals df(k) die einzelnen Verstärkungsfaktoren zugewiesen sind.

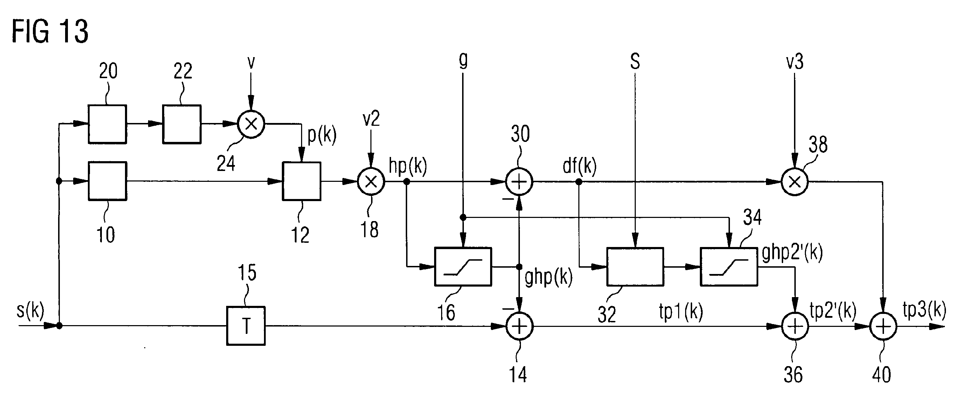

Figur 13 zeigt eine Abwandlung der Filteranordnung gemäß Figur 12, wobei sich diese Tiefpassfilteranordnung gemäß von der in Figur 12 dargestellten dadurch unterscheidet, dass das Differenzsignal df(k) neben der Filterung mittels des Filters 32 und der Begrenzung 34 einer Gewichtung mit einem einstellbaren Gewichtungsfaktor v3 mittels einer Gewichtungseinheit 38 unterzogen wird, wobei ein am Ausgang der Gewichtungseinheit 38 anliegendes Signal mittels eines Addierers 40 zu dem Ausgangssignal tp2 (k) des Addierers 36 hinzu addiert wird.

Wie anhand der Figuren 6 bis 8 erläutert wurde, besitzt eine Tiefpassfilterung mit Filteranordnungen gemäß der Figuren 6 und 7 -und auch gemäß der Figuren 10 bis 13- den Nachteil, dass Impulse des Eingangssignals s(k) in ihrer Amplitude abhängig von einem Gewichtungsfaktor, mit dem das hochpassgefilterte Signal hp(k) vor der Subtraktion von dem Eingangssignal gewichtet wird, gedämpft werden.

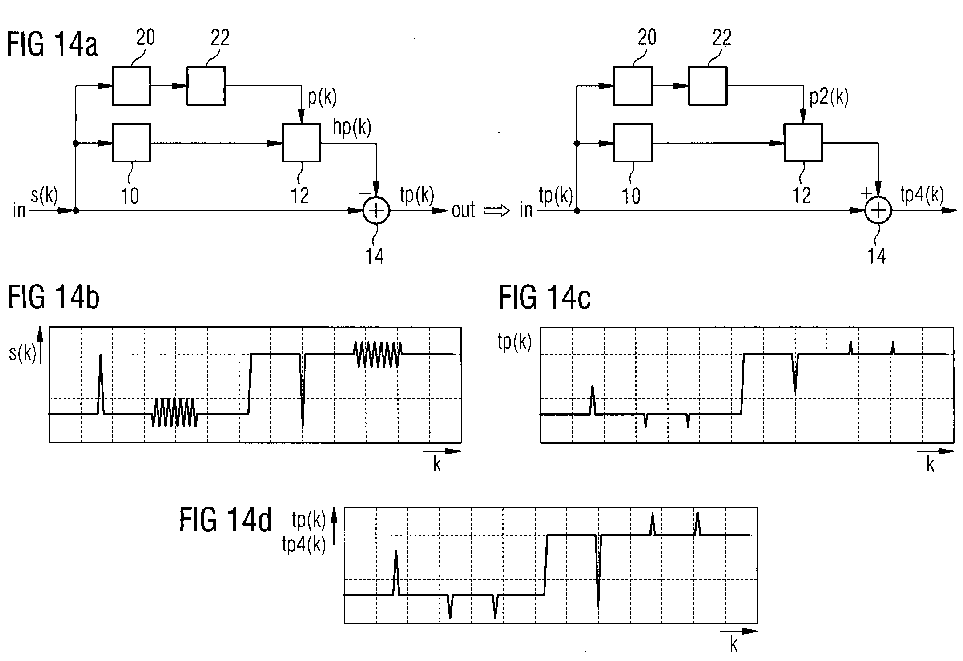

Wie in Figur 14 dargestellt ist, kann dieses Problem dadurch behoben werden, dass der ersten Filteranordnung mit dem erfindungsgemäßen Hochpassfilter HP1 eine weitere Filteranordnung nachgeschaltet ist, die ebenfalls ein erfindungsgemäßes Hochpassfilter aufweist, das vorzugsweise identisch zu dem Hochpassfilter HP1 der ersten Filteranordnung ausgebildet ist. Die zweite Filteranordnung, deren Eingang das Ausgangssignal tp(k) der ersten Filteranordnung zugeführt ist, unterscheidet sich von der ersten Filteranordnung dadurch, dass das am Ausgang des Hochpassfilters anliegende Signal zu dem Eingangssignal hinzuaddiert wird, um in dem Ausführungsbeispiel ein Filterausgangssignal tp4(k) zur Verfügung zu stellen. Während die erste Filteranordnung Impulse des Eingangssignals s(k) bezüglich ihrer Amplitude halbiert, wie ein Vergleich zwischen dem Eingangssignal s(k) und dem am Ausgang der ersten Filteranordnung anliegenden Signal tp (k) in den Figuren 14b und 14c zeigt, werden in der zweiten Filteranordnung diese Impulse mittels der Hochpassfilteranordnung erneut herausgefiltert, jedoch zu dem Eingangssignal hinzuaddiert, um dadurch in dem resultierenden Filtersignal tp4(k) die Impulse mit ihrer ursprünglichen Amplitude wieder herzustellen.

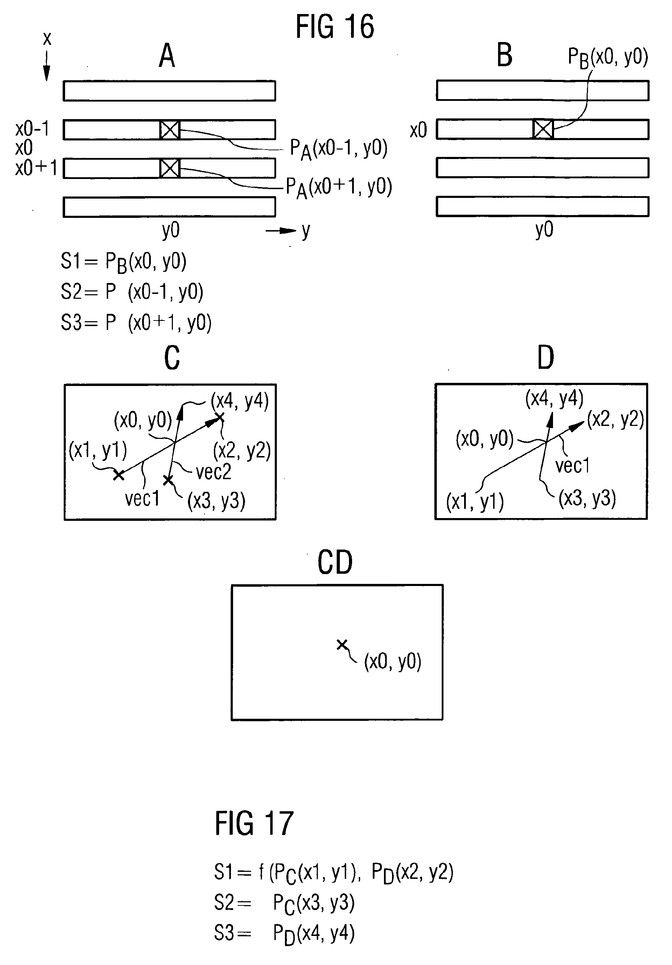

Die Verbesserung des Übertragungsverhaltens des Systems gemäß Figur 14 mit der Tiefpassfilteranordnung, die hochfrequente Signalanteile herausfiltert und den nachgeschalteten Filteranordnungen, die in dem Ausgangssignal der ersten Filteranordnung enthaltenen hochfrequenten Signalanteile verstärkt, gegenüber einem herkömmlichen derartigen System wird anhand von Figur 16 deutlich. Figur 16a zeigt ein System nach dem Stand der Technik, das entsprechend dem System gemäß Figur 14 aufgebaut ist, bei dem anstelle der erfindungsgemäßen Hochpassfilteranordnungen herkömmliche Hochpassfilter verwendet werden. Diese Hochpassfilter sind in Figur 16a mit dem Bezugszeichen 200 bezeichnet. Addierer dieses Systems, die den Addierern 14, 114 des Systems gemäß Figur 14a entsprechen, sind in Figur 16a mit dem Bezugszeichen 210, 220 bezeichnet.

Dem System gemäß Figur 16 ist ein Eingangssignal in(k) zugeführt, das dem Signal s(k) gemäß Figur 14b entspricht. Für die Übertragungsfunktion der Hochpassfilter 200 wird angenommen, dass diese Übertragungsfunktion der Übertragungsfunktion der Hochpassfilter 10 gemäß Figur 14a entspricht. Ein Vergleich der Ausgangssignale out(k) bei dem System nach dem Stand der Technik und tp4(k) bei dem erfindungsgemäßen System macht deutlich, dass bei dem erfindungsgemäßen System Kanten im Signalverlauf vollständig erhalten bleiben, während diese bei dem bekannten System abgeflacht sind, und weiterhin, dass auch Impulse bei dem System mit den erfindungsgemäßen Hochpassfilteranordnungen vollständig erhalten bleiben, während diese bei dem System nach dem Stand der Technik in ihrer Amplitude reduziert werden.

Zusammenfassend ist festzustellen, dass das erfindungsgemäße Hochpassfilterverfahren und eine erfindungsgemäße Hochpassfilteranordnung mit einer adaptiv eingestellten Coring-Einheit vielseitig anwendbar ist und dass die erfindungsgemäße Hochpassfilteranordnung gegenüber herkömmlichen linearen Hochpassfilteranordnungen insbesondere bei der Filterung von Sprungsignalen vorteilhaft ist.

Für die bisherige Erläuterung des erfindungsgemäßen Verfahrens wurde davon ausgegangen, dass die verarbeiteten Signalwerte einer Signalfolge mit zeitlich oder räumlich aufeinanderfolgenden Signalwerten entstammen, wobei zu jedem Eingangswert unter Verwendung benachbarter Werte ein Ausgangswert erzeugt wird. Die am Ausgang bereitgestellte Signalfolge stellt sich dabei je nach konkreter Asugestaltung des Verfahrens als hochpassgefilterte oder tiefpassgefilterte Eingangsfolge dar.

Das erfindungsgemäße Verfahren ist jedoch nicht auf die Verarbeitung von Signalfolgen mit zeitlich oder räumlich aufeinanderfolgenden Signalwerten beschränkt sondern ist auch auf anderweitig erzeugte Signalwerte anwendbar, wie nachfolgend erläutert wird, wobei im Folgenden der erste Signalwert S1 den bisherigen ersten Signalwert s(i), der zweite Signalwert S2 den bisherigen zweiten Signalwert s(i-1) und der dritte Signalwert S3 den bisherigen dritten Signalwert s(i+1) ersetzt.

Figur 15 zeigt eine Abwandlung der Vorrichtung gemäß Figur 7. Die Vorrichtung gemäß Figur 7 dient zur Anwendung des erfindungsgemäßen Verfahrens auf eine Eingangsfolge s(k) aufeinanderfolgender Signalwerte, wobei die Filter 10, 20 Verzögerungsglieder 107, 108, 207, 208 umfassen, um drei aufeinanderfolgende Signalwerte verarbeiten und aus diesen drei aufeinanderfolgenden Signalwerten einen Filterausgangswert hp(k) bzw. tp(k) zur Verfügung zu stellen.

Bei der Vorrichtung gemäß Figur 15 ist auf diese Verzögerungsglieder gemäß Figur 7 verzichtet und der Vorrichtung sind stattdessen parallel ein erster Signalwert S1, ein zweiter Signalwert S2 und ein dritter Signalwert S3 zugeführt.

Davon ausgehend, dass in Figur 7 gleichzeitig durch die beiden Filter 10, 20 ein momentaner Eingangswert s(k), ein um 1 verzögerter Eingangswert s(k-1) und einem um 2 verzögerter Eingangswert s(k-2) verarbeitet wird, entspricht die Verarbeitung des ersten Signalwertes S1 der Verarbeitung des Signalwertes s(k-1) gemäß Figur 7, die Verarbeitung des zweiten Signalwertes S2 der Verarbeitung des Signalwertes s(k) und die Verarbeitung des dritten Signalwertes S3 der Verarbeitung des Signalwertes s(k-2).

Die Vorrichtung gemäß Figur 15 ermittelt zu diesen drei Werten S1, S2, S3 ein Ausgangssignal hp (k) am Ausgang der Coring-Einheit 12 bzw. einen Filterausgangswert tp (k) am Ausgang des Subtrahierers 14. Der Filterausgangswert hp(k) bei der Vorrichtung gemäß Figur 15 entspricht einem Maß für einen gegenseitigen Abstand der Signalwerte S1, S2, S3. Der Filterwert tp(k), der den Ausgangswert hp(k) der Coring-Einheit von dem ersten Signalwert S1 subtrahiert, entspricht einem aus dem ersten, dem zweiten und dem dritten Signalwert S1, S2, S3 erzeugten Interpolationswert.

Diese Vorrichtung gemäß Figur 15 bzw. das zugrundeliegende Verfahren, das aus drei Signalwerten S1, S2, S3 einen interpolierten Wert tp(k) zur Verfügung stellt, eignet sich insbesondere zur Bildpunktinterpolation, wie nachfolgend anhand der Figuren 16 und 17 erläutert wird.

Figur 16 zeigt schematisch zwei aufeinanderfolgende zeilenverkämmte Halbbilder A, B einer Halbbildfolge, wobei das Halbbild A beispielsweise die geradzahligen Zeilen und das Halbbild B beispielsweise die ungeradzahligen Zeilen des Bildes umfasst. Um einen Bildinformationswert für den Bildpunkt an der Position (x0, y0), in dem Halbbild A, zu interpolieren ist vorgesehen, die Bildinformationswerte von drei Bildpunkten zu verwenden, die in Figur 16 mit $P_A$(x0-1, y0), $P_A$ (x0+1, y0) und $P_B$(x0, y0) bezeichnet sind. Der für das erfindungsgemäße Verfahren benötigte erste Signalwert S1 entspricht dabei dem Bildinformationswert $P_B$ (x0, y0) an der Position (x0, y0) in dem zweiten Halbbild B. Der zweite und dritte Signalwert S2, S3 entstammen dem ersten Halbbild A und sind die Bildpunkte, die zu dem interpolierenden Bildpunkt (x0, y0) in vertikaler Richtung benachbart sind, wobei der zweite Bildinformationswert S2 dem Wert des oberhalb des zu interpolierenden Bildpunktes liegenden Bildpunkt $P_A$(x0-1, y0) entspricht und der dritte Bildpunkt S3 dem Wert des unterhalb des zu interpolierenden Bildpunktes liegenden Bildpunkt $P_A$(x0-1, y0) entspricht.

Führt man diese drei Signalwerte S1, S2, S3 der Vorrichtung gemäß Figur 15 zu, bzw. wendet man auf diese drei Signalwerte das zuvor erläuterte Tiefpassfilterverfahren an, so entspricht der am Ausgang zu den drei Signalwerten S1, S2, S3 gelieferte Signalwert tp(k) dem zu interpolierenden Bildinformationswert $P_A$ (x0, y0).

Figur 17 zeigt schematisch zwei aufeinanderfolgende Bilder C, D zu denen ein zeitlich oder räumlich zwischen diesen beiden Bildern liegendes Zwischenbild CD unter Verwendung von Bewegungsvektoren interpoliert werden soll. (x0, y0) in dem zu interpolierenden Bild CD ist die Position eines der zu interpolierenden Bildpunkte. Diesem Bildpunkt sind zwei Bewegungsvektoren vec1, vec2 zugeordnet, deren räumliche Ausrichtung in den Bildern C, D dargestellt ist. Der Bildpunkt x0, y0 liegt jeweils auf diesen Bewegungsvektoren. Zur Interpolation des Bildpunktes $P_{CD}$(x0, y0) ist vorgesehen, die Bildinformationswerte $P_C$(x1, y1), $P_c$(x3, y3) an den Anfangspunkten (x1,y1 ) bzw. (x3, y3) des ersten und zweiten Bewegungsvektors vec1, vec2 in dem ersten Bild C und die Bildinformationswerte $P_D$(x2, y2) bzw. $P_D$(x4, y4) an den Endpunkten (x2, y2) und (x4, y4) an den Endpunkten des ersten und zweiten Bewegungsvektors vec1, vec2 in dem zweiten Bild D heranzuziehen. Der gemäß dem erfindungsgemäßen Verfahren zu verarbeitende erste Signalwert S1 entspricht dabei einem Mischwert des Bildinformationswertes an dem Anfangspunkt des ersten Vektors vec1 in dem ersten Bild C und am Endpunkt dieses ersten Vektors vec1 in dem zweiten Bild D, wobei der Mischwert vorzugsweise der Mittelwert ist, so dass gilt:

$$S1 = (P_c(x1, y1) + P_D(x2, y2))/2$$

Der zweite zu verarbeitende Signalwert S2 entspricht dem Bildinformationswert $P_c$(x3, y3) an dem Anfangspunkt des zweiten Vektors vec2 in dem ersten Bild C und der dritte zu verarbeitende Signalwert S3 entspricht dem Bildinformationswert $P_D$(x4, y4) an dem Endpunkt (x4, y4) des zweiten Vektors vec2 in dem zweiten Bild D.

Führt man diese Signalwerte S1, S2, S3 der Vorrichtung gemäß Figur 15 zu bzw. wendet man auf diese Signalwerte das zuvor erläuterte Tiefpassfilterverfahren an, so entspricht der zur Verfügung gestellte Signalwert tp(k) dem zu interpolierenden Bildinformationswert $P_{CD}$(x0, y0).

Wenngleich die Anwendung des erfindungsgemäßen Verfahrens auf die Bildpunktinterpolation anhand einer Abwandlung der Vorrichtung gemäß Figur 7 erläutert, wird darauf hingewiesen, dass selbstverständlich beliebige in der vorliegenden Anmeldung erläuterte Tiefpassfilterverfahren für die Bildpunktinterpolation einsetzbar sind, sofern die wenigstens drei verarbeiteten Signalwerte in der anhand der Figuren 16 und 17 erläuterten Weise bereitgestellt werden.

**Patentansprüche**

1. Verfahren zur Hochpassfilterung eines eine Folge von Signalwerten aufweisenden Signals (s(k)), um ein eine Folge von Signalwerten aufweisendes hochpassgefiltertes Signal (hp(k)) zur Verfügung zu stellen, wobei das Verfahren zur Erzeugung eines Signalwertes (hp (i)) des gefilterten Signals (hp(k)) folgende Verfahrensschritte umfasst:

   a) Auswählen eines ersten Signalwertes (s(i)) des zu filternden Signals (s(k)) und wenigstens eines dem ersten Signalwert (s(i)) in der Signalfolge (s(k)) vorausgehenden zweiten Signalwertes (s(i-1)) und wenigstens eines dem ersten Signalwert (s(i)) in der Signalfolge (s(k)) nachfolgenden dritten Signalwertes (s(i+1)),

b) Ermitteln eines durch den wenigstens einen zweiten Signalwert (s(i-1)) und den wenigstens einen dritten Signalwert (s(i+1)) vorgegebenen Intervalls, mit einer von dem wenigstens einen zweiten Signalwert (s(i-1)) abhängigen ersten Intervallgrenze und einer durch den wenigstens einen dritten Signalwert (s(i+1)) vorgegeben zweiten Intervallgrenze,

c) Ermitteln eines Mittelwertes (m) aus dem wenigstens einen ausgewählten zweiten Signalwert (s(i-1)) und dem wenigstens einen ausgewählten dritten Signalwert (s(i+1)),

d) Ermitteln, ob der erste Signalwert (s(i)) innerhalb des Intervalls liegt,

e) wenn der erste Signalwert (s(i)) außerhalb des Intervalls liegt: Ermitteln eines ersten mathematischen Abstands (d1) zwischen dem ersten Signalwert (s(i)) und der ersten Intervallgrenze (s(i-1)) und eines zweiten mathematischen Abstands (d2) zwischen dem ersten Signalwert (s(i)) und der zweiten Intervallgrenze (s(i+1)) und eines dritten mathematischen Abstandes zwischen (d3) zwischen dem ersten Signalwert (s(i)) und dem Mittelwert (m) zur Bereitstellung eines ersten, eines zweiten und eines dritten Abstandswertes, Auswählen eines Wertes aus einem Wertebereich zwischen dem kleineren der ersten und zweiten Abstandswerte (d1, d2) und dem dritten Abstandswert (d3),

f) wenn der erste Signalwert (s(i)) innerhalb des Intervalls liegt: Auswählen eines Wertes aus einem Wertebereich zwischen Null und der Hälfte der Intervallbreite,

g) Setzen des Vorzeichens des ausgewählten Signalwertes abhängig von der Lage des ersten Signalwertes (s(i)) bezogen auf den Mittelwert (m), um den gefilterten Signalwert (hp(k)) bereitzustellen.

2. Verfahren nach Anspruch 1, bei dem der in den Schritten e) oder f) ausgewählte Wert gewichtet wird.

3. Verfahren nach Anspruch 1, bei dem im Verfahrensschritt e) als ausgewählter Wert der kleinere der ersten und zweiten Abstandswerte (d1, d2) ausgewählt wird, und bei dem im Verfahrensschritt f) Null ausgewählt wird.

4. Verfahren nach einem der vorangehenden Ansprüche, bei dem das Vorzeichen des in den Verfahrensschritten e) oder f) ausgewählten Signalwertes im Verfahrensschritt g) positiv gesetzt wird, wenn der erste Signalwert (s(i)) größer als der Mittelwert (m) ist, und negativ gesetzt wird, wenn der erste (s(i)) Signalwert kleiner als der Mittelwert (m) ist.

5. Verfahren nach einem der vorangehenden Ansprüche, bei dem bei der Ermittlung des ersten, zweiten und/oder dritten Abstandes der jeweilige Abstandswert (d1, d2, d3) zu Null gesetzt wird, wenn Abstandswert kleiner als ein vorgegebener Grenzwert ist.

6. Verfahren nach einem der vorangehenden Ansprüche, bei dem der gefilterte Signalwert hp(k) auf einen oberen Grenzwert (g) und einen unteren Grenzwert (-g) begrenzt wird.

7. Verfahren nach einem der vorangehenden Ansprüche, bei dem mehr als ein zweiter Signalwert (s(i-1)) und/oder mehr als ein dritter Signalwert (s(i+1)) vorgesehen ist, wobei einer der zweiten Signalwerte als zweiter Signalwert (s(i-1)) und einer der dritten Signalwerte als dritter Signalwert (s(i+1)) ausgewählt wird.

8. Verfahren nach Anspruch 7, bei dem zwischen jedem der zweiten Signalwerte (s(i-1)) und jedem der dritten Signalwerte ein mathematischer Abstand ermittelt wird und derjenige zweite Signalwert und derjenige dritte Signalwert als erste und zweite Intervallgrenze ausgewählt werden, die den größten Abstand oder die den kleinsten Abstand besitzen.

9. Verfahren zur Tiefpassfilterung eines Eingangssignals, um ein tiefpassgefiltertes Signal (tp(k), tp2(k), tp3(k)) bereitzustellen, das folgende Verfahrensschritte umfasst:

   - Bereitstellen eines hochpassgefilterten Signals (hp(k)) nach einem Verfahren gemäß der Ansprüche 1 bis 7 aus einem zu filternden Eingangssignal (s(k)),

   - Erzeugen des tiefpassgefilterten Signals (tp(k), tp2(k), tp3(k)) aus dem hochpassgefilterten Signal (hp(k)) und dem Eingangssignal s(k)).

10. Verfahren nach Anspruch 9, bei dem die Erzeugung des tiefpassgefilterten Signals (tp(k)) eine Subtraktion des hochpassgefilterten Signals (hp(k)) von dem Eingangssignal (s(k)) umfasst.

11. Verfahren nach Anspruch 10, bei dem das hochpassgefilterte Signal (hp(k)) vor der Subtraktion verstärkt oder gedämpft wird.

12. Verfahren nach einem der Ansprüche 9 bis 11, bei dem die Erzeugung des tiefpassgefilterten Signals (tp2(k)) folgende Verfahrensschritte umfasst:

13

- Begrenzen des hochpassgefilterten (hp(k)) Signals zur Erzeugung eines begrenzten hochpassgefilterten (ghp(k)) Signals,

- Subtrahieren des begrenzten hochpassgefilterten Signals (ghp(k)) von dem Eingangssignal (s(k)) zur Erzeugung eines ersten tiefpassgefilterten Signals (tp1 (k)),

- Subtrahieren des begrenzten hochpassgefilterten Signals (ghp (k)) von dem hochpassgefilterten Signal (hp(k)) zur Erzeugung eines Differenzsignals (df(k)),

- Begrenzen eines von dem Differenzsignal (df (k)) abhängigen Signals,

- Addieren des ersten tiefpassgefilterten Signals (tp1 (k)) und des begrenzten Differenzsignals (df(k)) zur Bildung des tiefpassgefilterten Signals (tp2(k)).

13. Verfahren nach Anspruch 10, bei dem das Differenzsignals (df(k)) vor der Begrenzung gefiltert wird.

14. Verfahren nach Anspruch 13, bei dem die Filterung eine Verstärkung des Differenzsignals (df(k)) mit einem von der jeweiligen Amplitude des Differenzsignals (df(k)) abhängigen Verstärkungsfaktor umfasst.

15. Verfahren nach Anspruch 13 oder 14, bei dem das Differenzsignal (df(k)) gewichtet und das gewichtete Differenzsignal zu dem ersten tiefpassgefilterten Signal (tp1 (k) und dem begrenzten Differenzsignal (df(k)) addiert wird, um das tiefpassgefilterte Signal (tp3(k)) zu bilden.

16. Verfahren zur Filterung eines Eingangssignals (s (k)), das folgende Verfahrensschritte umfasst:

- Bereitstellen eines tiefpassgefilterten Signals (tp(k), tp1 (k), tp2(k), tp3(k)) nach einem Verfahren gemäß eines der Ansprüche 9 bis 15,

- Filtern dieses tiefpassgefilterten Signals mittels eines Verfahrens nach einem der Ansprüche 1 bis 8 zur Bereitstellung eines hochpassgefilterten Signals (hp2 (k)),

- Addieren des hochpassgefilterten Signals (hp2 (k)) zu dem tiefpassgefilterten Signal.

17. Hochpassfilteranordnung (1), zur Filterung eines eine Folge von Signalwerten aufweisenden Eingangssignals (s(k)):

- einen Eingang zur Zuführung des Eingangssignals (s(k)) und einen Ausgang zur Bereitstellung eines Filterausgangssignals (hp (k)),

- ein erstes Hochpassfilter (10, 20) und zweites Hochpassfilter, die jeweils dem Eingang nachgeschaltet sind,

- eine Coring-Einheit (12) mit einem Signaleingang, dem ein von einem Filterausgangssignal des ersten Hochpassfilters (10) abhängiges Signal (hp1 (k)) zugeführt ist, mit einem Steuereingang, dem ein von einem Signal am Ausgang des zweiten Hochpassfilters (20) abhängiges Signal p(k)) zugeführt ist, und mit einem Ausgang, der an den Ausgang der Hochpassfilteranordnung (1) gekoppelt ist.

18. Filteranordnung nach Anspruch 17, bei der zwischen den Ausgang des zweiten Hochpassfilters (20) und den Steuereingang der Coring-Einheit (12) eine Anordnung (22) zur Betragsbildung geschaltet ist.

19. Filteranordnung nach Anspruch 17 oder 18, bei der zwischen den Ausgang des zweiten Hochpassfilters (20) und den Steuereingang der Coring-Einheit (12) eine Verstärkeranordnung (24) geschaltet ist.

20. Filteranordnung nach Anspruch 16, bei der die Verstärkeranordnung eine Verstärkung zwischen 0 und 1 besitzt.

21. Filteranordnung nach einem der Ansprüche 15 bis 18, bei. der das erste Hochpassfilter (10) eine Übertragungsfunktion H1(z) besitzt, für die gilt:

$$H1(z) = k1 \cdot [-z^{-2} + 2z^{-1} - 1],$$

wobei k1 eine Konstante ist.

22. Filteranordnung nach Anspruch 21, bei der die Konstante k1 gleich 0,5 oder gleich 0,25 ist.

23. Filteranordnung nach einem der Ansprüche 17 bis 22, bei der das zweite Hochpassfilter eine Übertragungsfunktion H2(z) besitzt für die gilt:

$$H2(z) = k2 \cdot [z^{-2} + 0 \cdot z^{-1} - 1],$$

wobei k2 eine Konstante ist.

24. Filteranordnung nach Anspruch 23, bei der die Konstante k2 gleich 0,5 ist.

25. Filteranordnung nach einem der Ansprüche 17 bis 24, beim dem die Coring-Einheit (12) ein Übertragungsverhalten besitzt, für das gilt:

$$c(k)= h(k)-p(k) \text{ für } h(k)>p(k),$$

$$c(k)= 0 \text{ für } -p(k) \leq h(k) \leq p(k),$$

$$c(k)= h(k)+p(k) \text{ für } h(k)<-p(k)$$

wobei $c(k)$ ein Signalwert am Ausgang der Coring-Einheit ($c(k)$), und $p(k)$ ein Signalwert am Steuereingang der Coring-Einheit (12) ist.

26. Filteranordnung nach einem der Ansprüche 17 bis 25, bei der zwischen den Ausgang der Coring-Einheit (12) und den Ausgang der Filteranordnung eine Begrenzungsanordnung (16) geschaltet ist.

27. Verwendung einer Hochpassfilteranordnung nach einem der Ansprüche 14 bis 23 in einer Tiefpassfilteranordnung, in der ein Eingangssignal ($s(k)$) mittels einer Verknüpfungsschaltung (14; 14, 30, 34, 36; 14, 30, 34, 36, 38, 40) mit dem Ausgangssignal der Hochpassfilteranordnung zur Bildung eines tiefpassgefilterten ($tp(k)$, $tp1(k)$, $tp2(k)$, $tp3(k)$) verknüpft ist.

28. Verfahren zur Erzeugung eines Filtersignalwertes, das folgende Verfahrensschritte umfasst:

a) Bereitstellen eines ersten Signalwertes S1, eines zweiten Signalwertes (S2) und eines dritten Signalwertes (S3),

b) Ermitteln eines durch den wenigstens einen zweiten Signalwert (S2) und den wenigstens einen dritten Signalwert (S3) vorgegebenen Intervalls, mit einer von dem wenigstens einen zweiten Signalwert (S2) abhängigen ersten Intervallgrenze und einer durch den wenigstens einen dritten Signalwert (S3) vorgegeben zweiten Intervallgrenze,

c) Ermitteln eines Mittelwertes (m) aus dem wenigstens einen ausgewählten zweiten Signalwert (S2) und dem wenigstens einen ausgewählten dritten Signalwert (S3),

d) Ermitteln, ob der erste Signalwert (S1) innerhalb des Intervalls liegt,

e) wenn der erste Signalwert (S1) außerhalb des Intervalls liegt: Ermitteln eines ersten mathematischen Abstands (d1) zwischen dem ersten Signalwert (S1) und der ersten Intervallgrenze (S2) und eines zweiten mathematischen Abstands (d2) zwischen dem ersten Signalwert (S1) und der zweiten Intervallgrenze (S3) und eines dritten mathematischen Abstandes zwischen (d3) zwischen dem ersten Signalwert (S1) und dem Mittelwert (m) zur Bereitstellung eines ersten, eines zweiten und eines dritten Abstandswertes, Auswählen eines Wertes aus einem Wertebereich zwischen dem kleineren der ersten und zweiten Abstandswerte (d1, d2) und dem dritten Abstandswert (d3),

f) wenn der erste Signalwert (S1) innerhalb des Intervalls liegt: Auswählen eines Wertes aus einem Wertebereich zwischen Null und der Hälfte der Intervallbreite,

g) Setzen des Vorzeichens des ausgewählten Signalwertes abhängig von der Lage des ersten Signalwertes (S1) bezogen auf den Mittelwert (m), um den gefilterten Signalwert ($hp(k)$) bereitzustellen.

29. Verfahren nach Anspruch 28, bei dem der gefilterte Signalwert von dem ersten Signalwert (S1) subtrahiert wird, um einen gefilterten Signalwert ($tp(k)$) bereitzustellen.

30. Verwendung eines Verfahrens nach Anspruch 29, zur Bildpunktinterpolation bei der Erzeugung eines Vollbildes aus ersten und zweiten aufeinanderfolgenden, zeilenverkämmten Halbbildern, wobei

- der erste Signalwert (S1) einem Bildinformationswert des zweiten Halbbildes (B) an der Position (x0, y0) des zu interpolierenden Bildpunktes entspricht,

- der zweite Signalwert (S2) einem Bildinformationswert des ersten Halbbildes (A) an einer ersten Position (x0-1, y0), die benachbart zu der Position (x0, y0) des zu interpolierenden Bildpunktes ist, entspricht,

- der dritte Signalwert (S3) einem Bildinformationswert des ersten Halbbildes (A) an einer zweiten Position (x0+1, y0), die benachbart zu der Position (x0, y0) des zu interpolierenden Bildpunktes ist, entspricht.

31. Verwendung eines Verfahrens nach Anspruch 29 zur vektorgestützten Interpolation eines Bildpunktes eines Zwischenbildes, das zeitlich oder örtlich zwischen einem ersten und zweiten Bild (C, D) liegt, wobei dem Bildpunkt wenigstens ein erster und ein zweiter Bewegungsvektor (vec1, vec2) zugeordnet ist und wobei

- der erste Signalwert (S1) einem Mischwert aus dem Bildinformnationswert des Bildpunktes am Anfangspunkt (x1, y1) des ersten Vektors (vec1) in dem ersten Bild (C) und des Bildpunktes am Endpunkt (x2, y2) des ersten Vektors (vec1) in dem zweiten Bild (D) entspricht,

- der zweite Signalwert (S2) dem Bildinformationswert des Bildpunktes am Anfangspunkt (x3, y3) des zweiten Vektors in dem ersten Bild (C) entspricht,

- der dritte Signalwert (S3) dem Bildinformationswert des Bildpunktes am Endpunkt (x4, y4) des zweiten Vektors (vec2) in dem zweiten Bild (D) entspricht.

32. Verfahren nach Anspruch 31, bei dem der Mischwert dem Mittelwert der Bildpunkte am Anfangs- und Endpunkt des ersten Vektors (vec1, vec2) in dem ersten und zweiten Bild (C, D) entspricht.

## FIG 1

$hp(k) \in [-d1; -d3]$

## FIG 2

$hp(k) \in [0; -t/2]$

FIG 3

FIG 4a

FIG 4b

## FIG 5

## FIG 6

FIG 7

EP 1 489 742 A2

FIG 8a

FIG 8b

# FIG 9a

# FIG 9b

Tiefpassfilterung angewendet auf jeden geraden Eingangswert

# FIG 9c

Tiefpassfilterung angewendet auf jeden ungeraden Eingangswert

FIG 10

## FIG 11

FIG 12

# FIG 13

EP 1 489 742 A2

EP 1 489 742 A2

## FIG 14a

## FIG 14b

## FIG 14c

## FIG 14d

FIG 15

EP 1 489 742 A2

## FIG 16

### A

x0-1
x0
x0+1

$P_A(x0-1, y0)$
$P_A(x0+1, y0)$

y0

$S1 = P_B(x0, y0)$
$S2 = P\ (x0-1, y0)$
$S3 = P\ (x0+1, y0)$

### B

$P_B(x0, y0)$

x0

y0

### C

(x4, y4)
(x0, y0)
(x1, y1)
(x2, y2)
vec2
vec1
(x3, y3)

### D

(x4, y4)
(x2, y2)
(x0, y0)
vec1
(x1, y1)
(x3, y3)

### CD

(x0, y0)

## FIG 17

$S1 = f(P_C(x1, y1),\ P_D(x2, y2)$
$S2 = \quad P_C(x3, y3)$
$S3 = \quad P_D(x4, y4)$

FIG 18a  Stand der Technik

FIG 18b  Stand der Technik

Eingangssignal

FIG 18c  Stand der Technik

Ausgangssignal

EP 1 489 742 A2

FIG 19  Stand der Technik

200

in(k)

210

200

in2(k)              out(k)

220

in(k)

k

in2(k)

k

out(k)

k